# EUROPEAN PATENT SPECIFICATION

(11) **EP 1 500 128 B1**
(45) Date of publication and mention of the grant of the patent: **20.06.2007**
(21) Application number: 03798815.1
(22) Date of filing: 30.09.2003
(51) Int. Cl.: H01L 21/00

(54) **METHOD AND APPARATUS FOR DRYING SEMICONDUCTOR WAFER SURFACES USING A PLURALITY OF INLETS AND OUTLETS HELD IN CLOSE PROXIMITY TO THE WAFER SURFACES**
VERFAHREN UND APPARAT ZUM TROCKNEN VON HALBLEITERSCHEIBENOBERFLÄCHEN MITTELS EINER VIELZAHL VON EIN- UND AUSLÄSSEN IN DER NÄHE DER SCHEIBENOBERFLÄCHE
PROCEDE ET DISPOSITIF DESTINES A SECHER DES SURFACES DE PLAQUETTES DE SEMI-CONDUCTEUR AU MOYEN D'UNE PLURALITE D'ENTREES ET DE SORTIES MAINTENUES AU VOISINAGE IMMEDIAT DES SURFACES DE PLAQUETTES

(30) Priority: 30.09.2002 US 261839; 30.06.2003 US 611140
(43) Date of publication of application: 26.01.2005
(60) Divisional application: 07007143.6
(73) Proprietor: LAM RESEARCH CORPORATION, Fremont, CA 94538-6470 (US)
(72) Inventor: DE LARIOS, John, M., Palo Alto, CA 94303 (US); GARCIA, James, P., Santa Clara, CA 95050 (US); WOODS, Carl, Aptos, CA 95004 (US); RAVKIN, Mike, Sunnyvale, CA 94087 (US); REDEKER, Fritz, Fremont, CA 94539 (US); BOYD, John, c/o Lam Research Corporation, Fremont, CA 94538 (US); NICKHOU, Afshin, San Jose, CA 95120 (US)
(74) Representative: Thomson, Paul Anthony
(86) International application number: PCT/US2003/031136
(87) International publication number: WO 2004/030052

(56) References cited:
- EP-A- 0 905 746
- WO-A-02/01613
- WO-A-02/32825
- WO-A-99/16109
- US-A- 5 975 098
- US-A1- 2002 125 212

## Description

### BACKGROUND OF THE INVENTION

### 1. Field of the Invention

The present invention relates to semiconductor wafer cleaning and drying and, more particularly, to apparatuses and techniques for more efficiently removing fluids from wafer surfaces while reducing contamination and decreasing wafer cleaning cost.

### 2. Description of the Related Art

In the semiconductor chip fabrication process, it is well-known that there is a need to clean and dry a wafer where a fabrication operation has been performed that leaves unwanted residues on the surfaces of wafers. Examples of such a fabrication operation include plasma etching (*e.g*., tungsten etch back (WEB)) and chemical mechanical polishing (CMP). In CMP, a wafer is placed in a holder which pushes a wafer surface against a rolling conveyor belt. This conveyor belt uses a slurry which consists of chemicals and abrasive materials to cause the polishing. Unfortunately, this process tends to leave an accumulation of slurry particles and residues at the wafer surface. If left on the wafer, the unwanted residual material and particles may cause, among other things, defects such as scratches on the wafer surface and inappropriate interactions between metallization features. In some cases, such defects may cause devices on the wafer to become inoperable. In order to avoid the undue costs of discarding wafers having inoperable devices, it is therefore necessary to clean the wafer adequately yet efficiently after fabrication operations that leave unwanted residues.

After a wafer has been wet cleaned, the wafer must be dried effectively to prevent water or cleaning fluid remnants from leaving residues on the wafer. If the cleaning fluid on the wafer surface is allowed to evaporate, as usually happens when droplets form, residues or contaminants previously dissolved in the cleaning fluid will remain on the wafer surface after evaporation (e.g., and form spots). To prevent evaporation from taking place, the cleaning fluid must be removed as quickly as possible without the formation of droplets on the wafer surface. In an attempt to accomplish this, one of several different drying techniques are employed such as spin drying, IPA, or Marangoni drying. All of these drying techniques utilize some form of a moving liquid/gas interface on a wafer surface which, if properly maintained, results in drying of a wafer surface without the formation of droplets. Unfortunately, if the moving liquid/gas interface breaks down, as often happens with all of the aforementioned drying methods, droplets form and evaporation occurs resulting in contaminants being left on the wafer surface.

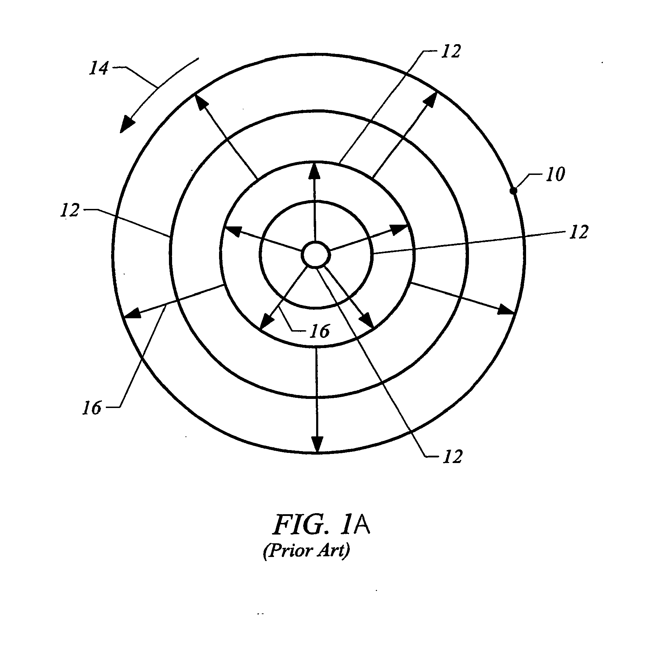

The most prevalent drying technique used today is spin rinse drying (SRD). Figure 1A illustrates movement of cleaning fluids on a wafer 10 during an SRD drying process. In this drying process, a wet wafer is rotated at a high rate by rotation 14. In SRD, by use of centrifugal force, the water or cleaning fluid used to clean the wafer is pulled from the center of the wafer to the outside of the wafer and finally off of the wafer as shown by fluid directional arrows 16. As the cleaning fluid is being pulled off of the wafer, a moving liquid/gas interface 12 is created at the center of the wafer and moves to the outside of the wafer (i.e., the circle produced by the moving liquid/gas interface 12 gets larger) as the drying process progresses. In the example of Figure 1A, the inside area of the circle formed by the moving liquid/gas interface 12 is free from the fluid and the outside area of the circle formed by the moving liquid/gas interface 12 is the cleaning fluid. Therefore, as the drying process continues, the section inside (the dry area) of the moving liquid/gas interface 12 increases while the area (the wet area) outside of the moving liquid/gas interface 12 decreases. As stated previously, if the moving liquid/gas interface 12 breaks down, droplets of the cleaning fluid form on the wafer and contamination may occur due to evaporation of the droplets. As such, it is imperative that droplet formation and the subsequent evaporation be limited to keep contaminants off of the wafer surface. Unfortunately, the present drying methods are only partially successful at the prevention of moving liquid interface breakdown.

In addition, the SRD process has difficulties with drying wafer surfaces that are hydrophobic. Hydrophobic wafer surfaces can be difficult to dry because such surfaces repel water and water based (aqueous) cleaning solutions. Therefore, as the drying process continues and the cleaning fluid is pulled away from the wafer surface, the remaining cleaning fluid (if aqueous based) will be repelled by the wafer surface. As a result, the aqueous cleaning fluid will want the least amount of area to be in contact with the hydrophobic wafer surface. Additionally, the aqueous cleaning solution tends cling to itself as a result of surface tension (i.e., as a result of molecular hydrogen bonding). Therefore, because of the hydrophobic interactions and the surface tension, balls (or droplets) of aqueous cleaning fluid forms in an uncontrolled manner on the hydrophobic wafer surface. This formation of droplets results in the harmful evaporation and the contamination discussed previously. The limitations of the SRD are particularly severe at the center of the wafer, where centrifugal force acting on the droplets is the smallest. Consequently, although the SRD process is presently the most common way of wafer drying, this method can have difficulties reducing formation of cleaning fluid droplets on the wafer surface especially when used on hydrophobic wafer surfaces.

The use of acoustic energy is a highly advanced, non-contact, cleaning technology for removing small-particles from substrates such as semiconductor wafers in various states of fabrication, flat panel displays, micro-electro-mechanical systems (MEMS), micro-opto-electro-mechanical systems (MOEMS), and the like. The cleaning process typically involves the propagation of acoustic energy through a liquid medium to remove particles from, and clean, a surface of a substrate. The megasonic energy is typically propagated in a frequency range of between about 600 kHz (0.6 Megahertz (MHz)) to about 1.5 MHz, inclusive. The typical liquid medium that can be utilized is deionized water or any one or more of several substrate cleaning chemicals and combinations thereof such as a dilute ammonium hydroxide/hydrogen peroxide solution in DI water. The propagation of acoustic energy through a liquid medium achieves non-contact substrate cleaning chiefly through the formation and collapse of bubbles from dissolved gases in the liquid medium, herein referred to as cavitation, microstreaming, and chemical reaction enhancement when chemicals are used as the liquid medium through improved mass transport, optimizing the zeta potential to favor particle entrainment in the liquid medium and inhibiting re-deposition, or providing activation energy to facilitate the chemical reactions.

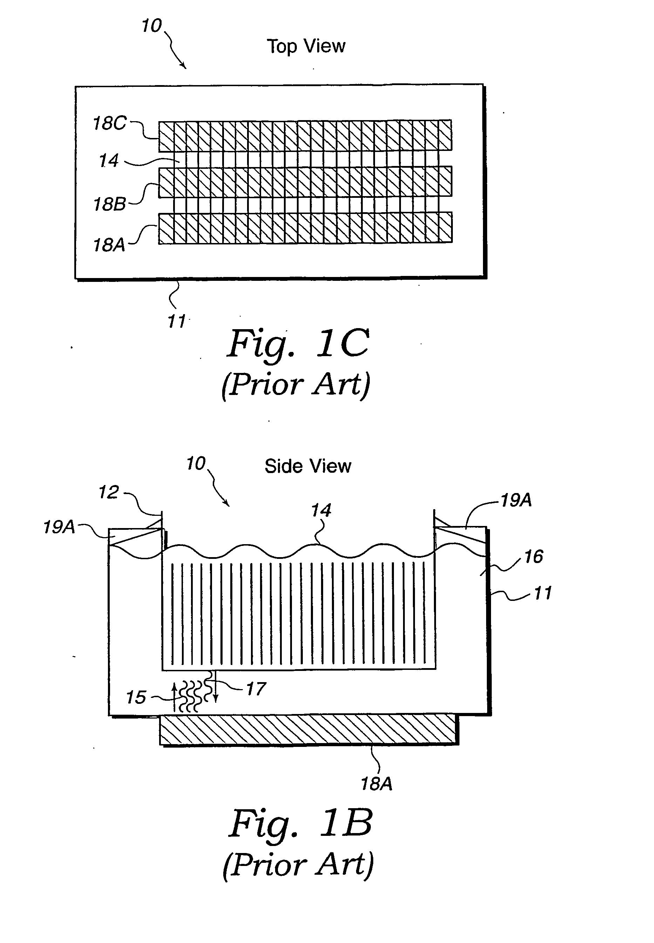

Figure 1B is a diagram of a typical batch substrate cleaning system 10. Figure 1C is a top view of the batch substrate cleaning system 10. A tank 11 is filled with a cleaning solution 16 such as deionized water or other substrate cleaning chemicals. A substrate carrier 12, typically a cassette of substrates, holds a batch of substrates 14 to be cleaned. One or more transducers 18A, 18B, 18C generate the emitted acoustic energy 15 that is propagated through the cleaning solution 16. The relative location and distance between the substrates 14 and the transducers 18A, 18B and 18C are typically approximately constant from one batch of substrates 14 to another through use of locating fixtures 19A, 19B that contact and locate the carrier 12.

The emitted energy 15, with or without appropriate chemistry to control particle re-adhesion, achieves substrate cleaning through cavitation, acoustic streaming, and enhanced mass transport if cleaning chemicals are used. A batch substrate cleaning process typically requires lengthy processing times, and also can consume excessive volumes of cleaning chemicals 16. Additionally, consistency and substrate-to-substrate control are difficult to achieve.

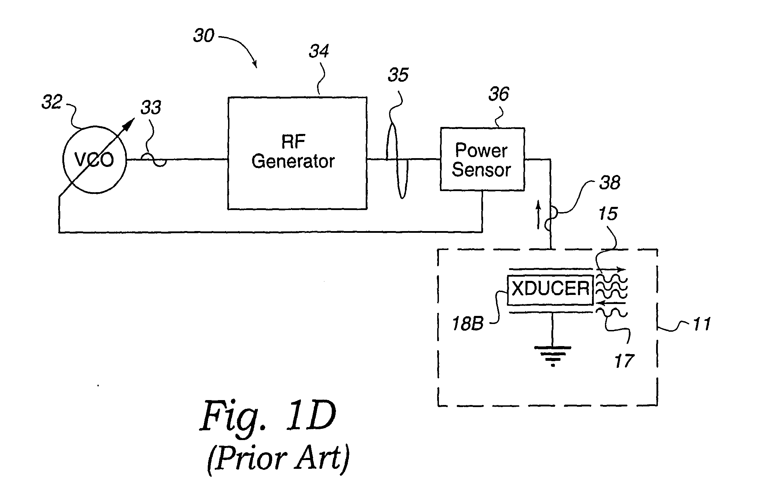

Figure 1D is a prior art, schematic 30 of an RF supply to supply one or more of the transducers 18A, 18B, 18C. An adjustable voltage controlled oscillator (VCO) 32 outputs a signal 33, at a selected frequency, to an RF generator 34. The RF generator 34 amplifies the signal 33 to produce a signal 35 with an increased power. The signal 35 is output to the transducer 18B. A power sensor 36 monitors the signal 35. The transducer 18B outputs emitted energy 15.

Unfortunately, the typical megasonic system has the problem of slow chemical exchange and a large effective reactor chamber volume. This can lead to contaminants being left in a megasonic reaction chamber to be redeposited on the wafer. Consequently, this can lead to inefficient cleaning and lowered wafer processing yields. Further, hot-spots or cold spots in the batch cleaning system can be generated by constructive or destructive interference of the acoustic wave due to reflections from the substrates and tank walls. These hot or cold spots can either damage sensitive structures present on the substrate, or cause inefficient or non-uniform cleaning.

Therefore, there is a need for a method and an apparatus that avoids the prior art by enabling quick and efficient cleaning of a semiconductor wafer, but at the same time reducing the redeposition of contaminants on the wafer following a cleaning operation while using low amounts of cleaning fluid as well as providing a uniform power density delivery to the substrate without hot or cold spots. Such deposits of contamination as often occurs today reduce the yield of acceptable wafers and increase the cost of manufacturing semiconductor wafers.

Further examples of prior art arrangements are disclosed in:
EP-A-0 905 746 (IMEC INTER UNI MICRO ELECTR) 31 March 1999 (1999-03-31);
WO 99/16109A (IMEC INTER UNI MICRO ELECTR; MEURIS MARC (BE); HEYNS MARC (BE); ME) 1 April 1999 (1999-04-01);
WO 02/32825A (UNIV CALIFORNIA) 25 April 2002 (2002-04-25);
WO 02/01613A (APPLIED MATERIALS INC) 3 January 2002 (2002-01-03);
US 2002/125212A1 (MEURIS MARC ET AL.) 12 September 2002 (2002-09-12); and
US-A-5 975 098 (WATANABE KAZUHIRO ET AL.) 2 November 1999 (1999-11-02).

Therefore, there is also a need for a method and an apparatus that avoids the prior art by allowing quick and efficient cleaning and drying of a semiconductor wafer, but at the same time reducing the formation of numerous water or cleaning fluid droplets which may cause contamination to deposit on the wafer surface. Such deposits as often occurs today reduce the yield of acceptable wafers and increase the cost of manufacturing semiconductor wafers.

### SUMMARY OF THE INVENTION

Broadly speaking, the present invention fills these needs by providing a cleaning and drying apparatus that is capable of removing fluids from wafer surfaces quickly while at the same time reducing wafer contamination. It should be appreciated that the present invention can be implemented in numerous ways, including as a process, an apparatus, a system, a device or a method. Several inventive embodiments of the present invention are described below.

According to the present invention there is provided a substrate preparation system, comprising:
a head having a head surface, the head surface configured to be proximate to a surface of the substrate when in operation;
a first conduit adapted to deliver a first fluid to the surface of the substrate through the head;
a second conduit adapted to deliver a second fluid to the surface of the substrate through the head, the second fluid being different than the first fluid; and
a third conduit adapted to remove each of the first fluid and the second fluid from the surface of the substrate, the first conduit, the second conduit and the third conduit configured to act simultaneously when in operation.

Also according to the present invention there is provided a method for processing substrate, comprising:
applying a first fluid onto a surface of a substrate;
applying a second fluid onto the surface of the substrate, the second fluid being applied in close proximity to the application of the first fluid; and
removing the first fluid and the second fluid from the surface of the substrate, the removing being processed just as first fluid and the second fluid are applied to the surface of the substrate;
wherein the applying and the removing forming a controlled meniscus.

Further according to the present invention there is provided a substrate preparation apparatus to be used in substrate processing operations, comprising:
a proximity head being moveable toward a substrate surface, the proximity head including;
at least one of a first source inlet, the first source inlet adapted to apply a first fluid towards the substrate surface when the proximity head is in a position that is close to the substrate surface;
at least one of a second source inlet, the second source inlet adapted to apply a second fluid towards the substrate surface when the proximity head is in the position that is close to the substrate surface; and
at least one of a source outlet, the source outlet adapted to apply a vacuum pressure to remove the first fluid, the second fluid from the substrate surface when the proximity head is in the position that is close to the substrate surface.

Likewise according to the present invention there is provided a head used in a substrate preparation apparatus, comprising:
at least one of a first source inlet for delivering a first fluid to the surface of the substrate through the head;
at least one of a second source inlet for delivering a second fluid to the surface of the substrate through the head, the second fluid being different than the first fluid; and
at least one of a source outlet for removing each of the first fluid and the second fluid from the surface of the substrate, at least a portion of the at least one of the source outlet being located in between the at least one of the first source inlet and the at least one of the second source inlet, and the at least one of the first source inlet, the at least one of the second source inlet, and the at least one of the source outlet being configured to act simultaneously when in operation; and
a transducer being capable of applying acoustic energy to the first fluid;
wherein the at least one of the second source inlet surrounds at least a trailing edge side of the at least one of the source outlet.

The advantages of the present invention are numerous. Most notably, the apparatuses and methods described herein can effectively and efficiently clean a semiconductor wafer while reducing fluids and contaminants remaining on a wafer surface. Consequently, wafer processing and production may be increased and higher wafer yields may be achieved due to efficient wafer cleaning with lower levels of contamination. The present invention enables the improved cleaning through the use of vacuum fluid removal in conjunction with fluid input and megasonic application. The pressures generated on a wafer surface by the aforementioned forces enable optimal removal of contaminants at the wafer surface with a significant reduction in the redepositing of contamination as compared with other cleaning techniques. The present invention may utilize application of an isopropyl alcohol (IPA) vapor and cleaning chemistries towards a wafer surface along with generation of a vacuum near the wafer surface at substantially the same time. This enables both the generation and intelligent control of a meniscus and the reduction of wafer surface tension along a cleaning chemistry interface and therefore enables optimal removal of fluids from the wafer surface without leaving contaminants. At a substantially same time, megasonic waves may be applied to the meniscus to provide megasonic based wafer cleaning without the problems of typical megasonic applications. In addition, the cleaning meniscus generated by input of IPA, cleaning chemistries and output of fluids may be moved along the surface of the wafer to clean the wafer. Moreover, in an additional embodiment, the apparatus and methods described herein may both clean and dry the wafer while at the same time reducing contamination left on the wafer surfaces as compared with prior art cleaning and drying systems. Therefore, the present invention cleans wafer surfaces with extreme effectiveness while substantially reducing contaminant formation.

Additional advantages include efficiencies in drying and cleaning a semiconductor wafer while reducing fluids and contaminants remaining on a wafer surface. Consequently, wafer processing and production may be increased and higher wafer yields may be achieved due to efficient wafer drying with lower levels of contamination. The present invention enables the improved drying and cleaning through the use of vacuum fluid removal in conjunction with fluid input. The pressures generated on a fluid film at the wafer surface by the aforementioned forces enable optimal removal of fluid at the wafer surface with a significant reduction in remaining contamination as compared with other cleaning and drying techniques. In addition, the present invention may utilize application of an isopropyl alcohol (IPA) vapor and deionized water towards a wafer surface along with generation of a vacuum near the wafer surface at substantially the same time. This enables both the generation and intelligent control of a meniscus and the reduction of water surface tension along a deionized water interface and therefore enables optimal removal of fluids from the wafer surface without leaving contaminants. The meniscus generated by input of IPA, DIW and output of fluids may be moved along the surface of the wafer to clean and dry the wafer. Therefore, the present invention evacuates fluid from wafer surfaces with extreme effectiveness while substantially reducing contaminant formation due to ineffective drying such as for example, spin drying.

Other aspects and advantages of the present invention will become apparent from the following detailed description, taken in conjunction with the accompanying drawings, illustrating by way of example the principles of the present invention.

### BRIEF DESCRIPTION OF THE DRAWINGS

The present invention will be readily understood by the following detailed description in conjunction with the accompanying drawings. To facilitate this description, like reference numerals designate like structural elements.
Figure 1A illustrates movement of cleaning fluids on a wafer during an SRD drying process.
Figure 1B is a diagram of a typical batch substrate cleaning system.
Figure 1C is a top view of the batch substrate cleaning system.
Figure 1D is a prior art, schematic of an RF supply to supply one or more of the transducers.
Figure 2A shows a wafer cleaning and drying system in accordance with one embodiment of the present invention.
Figure 2B shows an alternate view of the wafer cleaning and drying system in accordance with one embodiment of present invention.
Figure 2C illustrates a side close-up view of the wafer cleaning and drying system holding a wafer in accordance with one embodiment of the present invention.
Figure 2D shows another side close-up view of the wafer cleaning and drying system in accordance with one embodiment of the present invention.
Figure 3A shows a top view illustrating the wafer cleaning and drying system with dual proximity heads in accordance with one embodiment of the present invention.
Figure 3B illustrates a side view of the wafer cleaning and drying system with dual proximity heads in accordance with one embodiment of the present invention. Figure 4A shows a top view of a wafer cleaning and drying system which includes multiple proximity heads for a particular surface of the wafer in accordance with one embodiment of the present invention.
Figure 4B shows a side view of the wafer cleaning and drying system which includes multiple proximity heads for a particular surface of the wafer in accordance with one embodiment of the present invention.
Figure 5A shows a top view of a wafer cleaning and drying system with a proximity head in a horizontal configuration which extends across a diameter of the wafer 108 in accordance with one embodiment of the present invention.
Figure 5B shows a side view of a wafer cleaning and drying system with the proximity heads in a horizontal configuration which extends across a diameter of the wafer in accordance with one embodiment of the present invention.
Figure 5C shows a top view of a wafer cleaning and drying system with the proximity heads in a horizontal configuration which is configured to clean and/or dry the wafer that is stationary in accordance with one embodiment of the present invention.
Figure 5D shows a side view of a wafer cleaning and drying system with the proximity heads in a horizontal configuration which is configured to clean and/or dry the wafer that is stationary in accordance with one embodiment of the present invention.
Figure 5E shows a side view of a wafer cleaning and drying system with the proximity heads in a vertical configuration enabled to clean and/or dry the wafer that is stationary in accordance with one embodiment of the present invention.
Figure 5F shows an alternate side view of a wafer cleaning and drying system that is shifted 90 degrees from the side view shown in Figure 5E in accordance with one embodiment of the present invention.
Figure 5G shows a top view of a wafer cleaning and drying system with a proximity head in a horizontal configuration which extends across a radius of the wafer in accordance with one embodiment of the present invention.
Figure 5H shows a side view of a wafer cleaning and drying system with the proximity heads and in a horizontal configuration which extends across a radius of the wafer in accordance with one embodiment of the present invention.
Figure 6A shows a proximity head inlet/outlet orientation that may be utilized to clean and dry the wafer in accordance with one embodiment of the present invention.
Figure 6B shows another proximity head inlet/outlet orientation that may be utilized to clean and dry the wafer in accordance with one embodiment of the present invention.
Figure 6C shows a further proximity head inlet/outlet orientation that may be utilized to clean and dry the wafer in accordance with one embodiment of the present invention.
Figure 6D illustrates a preferable embodiment of a wafer drying process that may be conducted by a proximity head in accordance with one embodiment of the present invention.
Figure 6E shows another wafer drying process using another source inlet/outlet orientation that may be conducted by a proximity head in accordance with one embodiment of the present invention.
Figure 6F shows another source inlet and outlet orientation where an additional source outlet may be utilized to input an additional fluid in accordance with one embodiment of the present invention.
Figure 7A illustrates a proximity head performing a drying operation in accordance with one embodiment of the present invention.
Figure 7B shows a top view of a portion of a proximity head in accordance with one embodiment of the present invention.
Figure 7C illustrates a proximity head with angled source inlets performing a drying operation in accordance with one embodiment of the present invention.
Figure 7D illustrates a proximity head with angled source inlets and angled source outlets performing a drying operation in accordance with one embodiment of the present invention.
Figure 8A illustrates a side view of the proximity heads for use in a dual wafer surface cleaning and drying system in accordance with one embodiment of the present invention.
Figure 8B shows the proximity heads in a dual wafer surface cleaning and drying system in accordance with one embodiment of the present invention.
Figure 9A shows a top view of a proximity head with a circular shape in accordance with one embodiment of the present invention.
Figure 9B shows a side view of the proximity head with a circular shape in accordance with one embodiment of the present invention.
Figure 9C illustrates a bottom view of the proximity head 106-1 with a circular shape in accordance with one embodiment of the present invention.
Figure 10A shows a proximity head with an elongated ellipse shape in accordance with one embodiment of the present invention.
Figure 10B shows a top view of the proximity head with an elongated ellipse shape in accordance with one embodiment of the present invention.
Figure 10C shows a side view of the proximity head with an elongated ellipse shape in accordance with one embodiment of the present invention.
Figure 11A shows a top view of a proximity head with a rectangular shape in accordance with one embodiment of the present invention.
Figure 11B shows a side view of the proximity head with a rectangular shape in accordance with one embodiment of the present invention.
Figure 11C illustrates a bottom portion of the proximity head in a rectangular shape in accordance with one embodiment of the present invention.
Figure 12A shows a proximity head with a partial rectangular and partial circular shape in accordance with one embodiment of the present invention.
Figure 12B shows a rear view of the proximity head with a partial rectangular and partial circular shape in accordance with one embodiment of the present invention.
Figure 12C shows a top view of the proximity head with a partial rectangular and partial circular shape in accordance with one embodiment of the present invention.
Figure 13A illustrates a top view of a proximity head with a circular shape similar to the proximity head shown in Figure 9A in accordance with one embodiment of the present invention.
Figure 13B shows the proximity head from a bottom view in accordance with one embodiment of the present invention.
Figure 13C illustrates the proximity head from a side view in accordance with one embodiment of the present invention.
Figure 14A shows a proximity head similar in shape to the proximity head shown in Figure 12A in accordance with one embodiment of the present invention.
Figure 14B illustrates a top view of the proximity head where one end is squared off while the other end is rounded in accordance with one embodiment of the present invention.
Figure 14C shows a side view of a square end of the proximity head in accordance with one embodiment of the present invention.
Figure 15A shows a bottom view of a 25 holes proximity head in accordance with one embodiment of the present invention.
Figure 15B shows a top view of the 25 holes proximity head in accordance with one embodiment of the present invention.
Figure 15C shows a side view of the 25 holes proximity head in accordance with one embodiment of the present invention.
Figure 16A illustrates a side view of the proximity heads for use in a wafer surface megasonic cleaning system in accordance with one embodiment of the present invention.
Figure 16B illustrates a side view of the proximity heads for use in a dual wafer surface megasonic cleaning system in accordance with one embodiment of the present invention.
Figure 17 illustrates a side view of a proximity head where a megasonic transducer is located between a source outlet and a source inlet in accordance with one embodiment of the present invention.
Figure 18 illustrates a side view of a proximity head with the configuration as discussed in reference to Figure 7A with a megasonic transducer is located between a source outlet and a source inlet on a leading edge side in accordance with one embodiment of the present invention.
Figure 19A shows a side view of proximity heads with a combination of a clean/megasonic region and a drying region in accordance with one embodiment of the present invention.
Figure 19B shows a side view of proximity heads with dual megasonic transducers in the clean/megasonic region in accordance with one embodiment of the present invention.
Figure 20 shows an exemplary process window with the plurality of source inlets and as well as the plurality of source outlets in accordance with one embodiment of the present invention.
Figure 21 shows a top view of a proximity head with a substantially rectangular shape in accordance with one embodiment of the present invention.

### DETAILED DESCRIPTION OF THE PREFERRED EMBODIMENTS

An invention for methods and apparatuses for cleaning and/or drying a wafer is disclosed. In the following description, numerous specific details are set forth in order to provide a thorough understanding of the present invention. It will be understood, however, by one of ordinary skill in the art, that the present invention may be practiced without some or all of these specific details. In other instances, well known process operations have not been described in detail in order not to unnecessarily obscure the present invention.

While this invention has been described in terms of several preferred embodiments, it will be appreciated that those skilled in the art upon reading the preceding specifications and studying the drawings will realize various alterations, additions, permutations and equivalents thereof. It is therefore intended that the present invention includes all such alterations, additions, permutations, and equivalents as fall within the true spirit and scope of the invention.

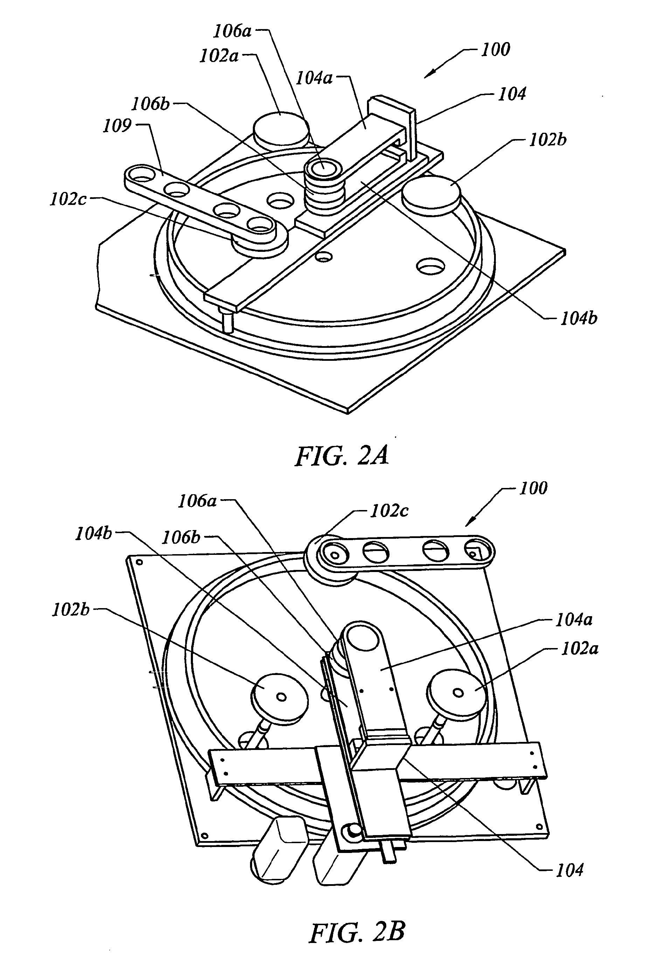

Figures 2A through 2D below illustrate embodiments of an exemplary wafer processing system. It should be appreciated that the system is exemplary, and that any other suitable type of configuration that would enable movement of the proximity head(s) into close proximity to the wafer may be utilized. In the embodiments shown, the proximity head(s) may move in a linear fashion from a center portion of the wafer to the edge of the wafer. It should be appreciated that other embodiments may be utilized where the proximity head(s) move in a linear fashion from one edge of the wafer to another diametrically opposite edge of the wafer, or other non-linear movements may be utilized such as, for example, in a circular motion, in a spiral motion, in a zig-zag motion, etc. In addition, in one embodiment, the wafer may be rotated and the proximity head moved in a linear fashion so the proximity head may process all portions of the wafer. It should also be understood that other embodiments may be utilized where the wafer is not rotated but the proximity head is configured to move over the wafer in a fashion that enables processing of all portions of the wafer. In addition, the proximity head and the wafer cleaning and drying system described herein may be utilized to clean and dry any shape and size of substrates such as for example, 200 mm wafers, 300 mm wafers, flat panels, etc. The wafer cleaning and drying system may be utilized for either or both cleaning and drying the wafer depending on the configuration of the system.

Figure 2A shows a wafer cleaning and drying system 100 in accordance with one embodiment of the present invention. The system 100 includes rollers 102a, 102b, and 102c which may hold and rotate a wafer to enable wafer surfaces to be dried. The system 100 also includes proximity heads 106a and 106b that, in one embodiment, are attached to an upper arm 104a and to a lower arm 104b respectively. The upper arm 104a and the lower arm 104b are part of a proximity head carrier assembly 104 which enables substantially linear movement of the proximity heads 106a and 106b along a radius of the wafer.

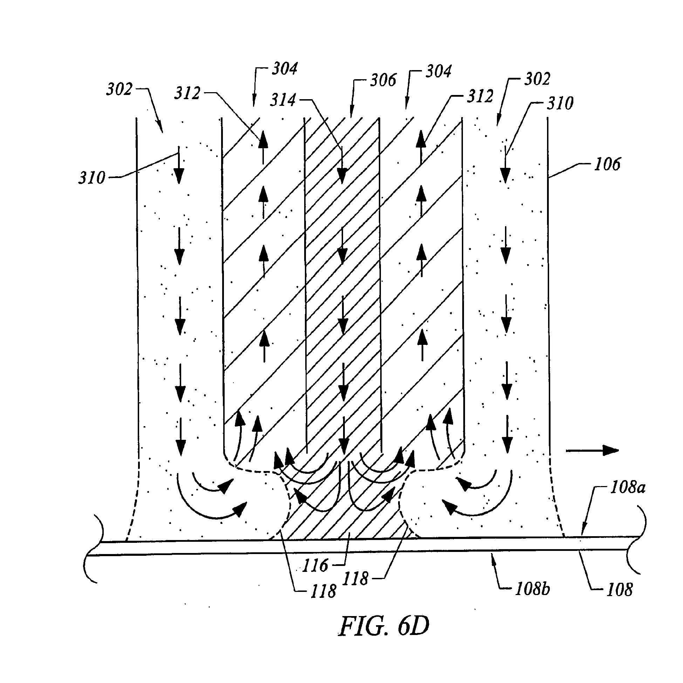

In one embodiment the proximity head carrier assembly 104 is configured to hold the proximity head 106a above the wafer and the proximity head 106b below the wafer in close proximity to the wafer. This may be accomplished by having the upper arm 104a and the lower arm 104b be movable in a vertical manner so once the proximity heads are moved horizontally into a location to start wafer processing, the proximity heads 106a and 106b can be moved vertically to a position in close proximity to the wafer. The upper arm 104a and the lower arm 104b may be configured in any suitable way so the proximity heads 106a and 106b can be moved to enable wafer processing as described herein. It should be appreciated that the system 100 may be configured in any suitable manner as long as the proximity head(s) may be moved in close proximity to the wafer to generate and control a meniscus as discussed below in reference to Figures 6D through 8B. It should also be understood that close proximity may be any suitable distance from the wafer as long as a meniscus as discussed in further reference to Figure 6D through 8B may be maintained. In one embodiment, the proximity heads 106a and 106b (as well as any other proximity head described herein) may each be moved to between about 0.1 mm to about 10 mm from the wafer to initiate wafer processing operations. In a preferable embodiment, the proximity heads 106a and 106b (as well as any other proximity head described herein) may each be moved to between about 0.5 mm to about 4.5 mm from the wafer to initiate wafer processing operations, and in more preferable embodiment, the proximity heads 106a and 106b (as well as any other proximity head described herein) may be moved to about 2 mm from the wafer to initiate wafer processing operations.

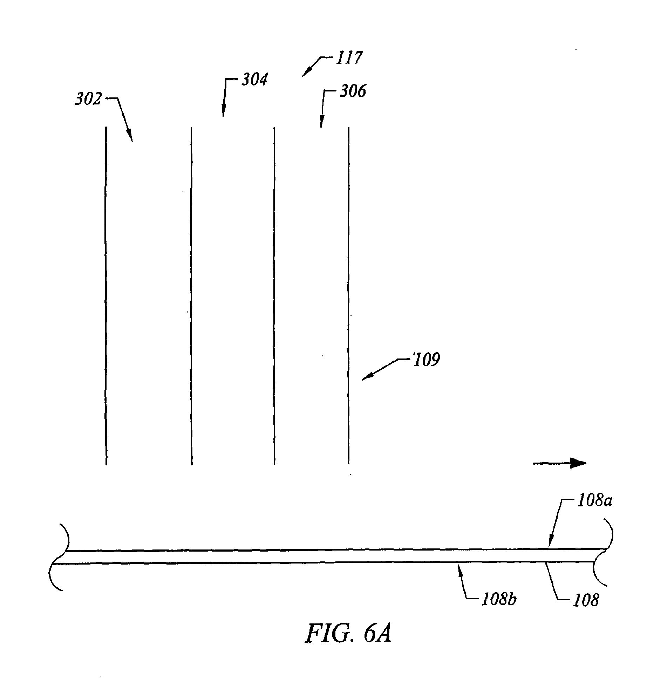

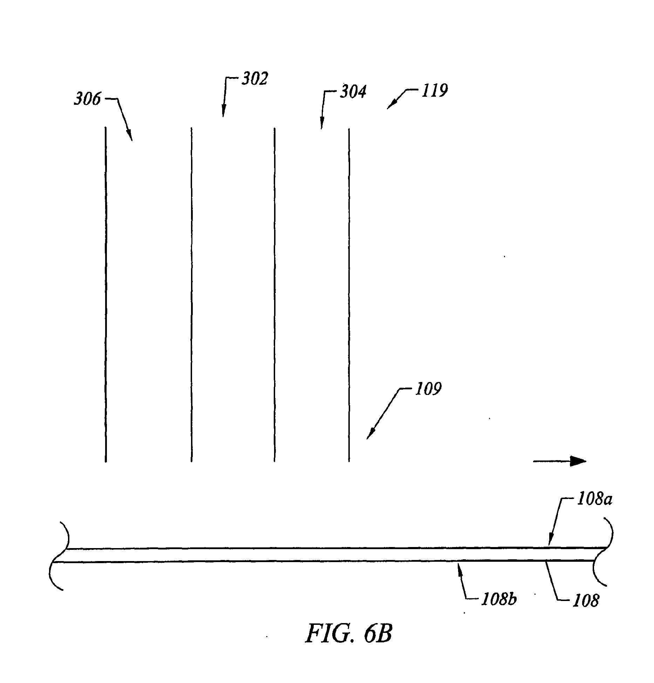

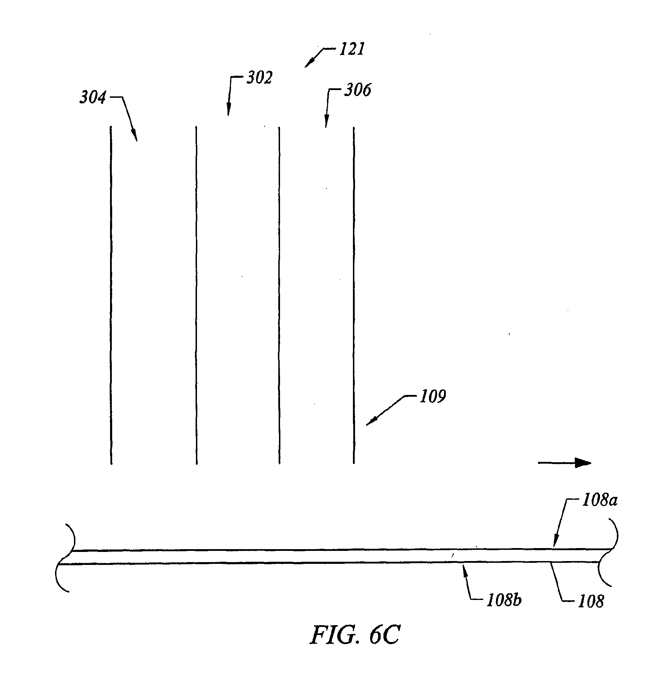

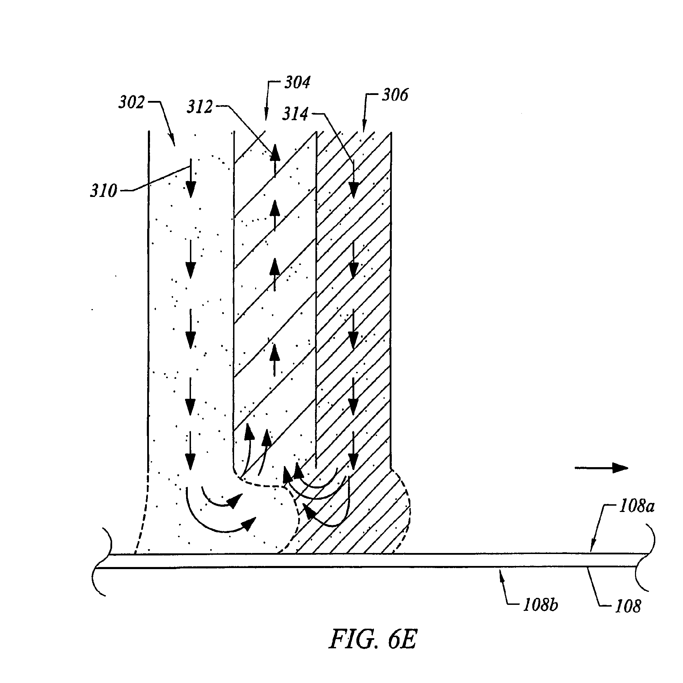

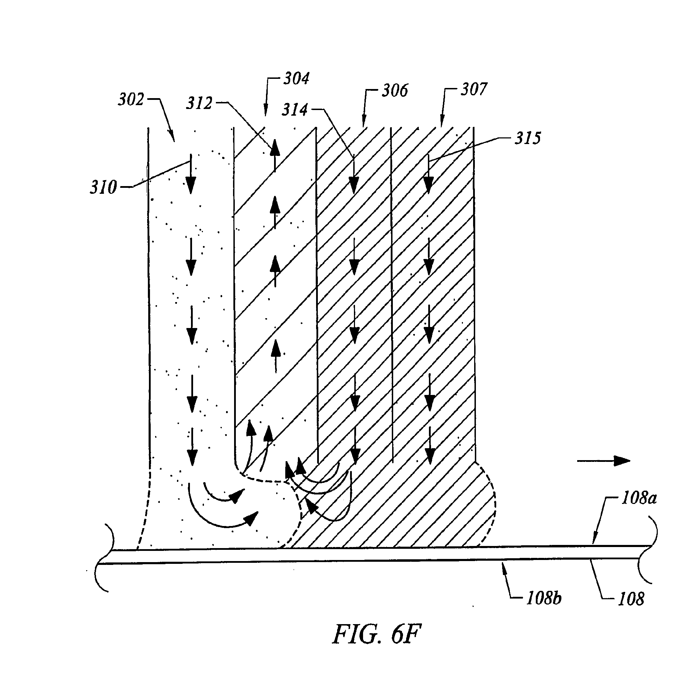

Figure 2B shows an alternate view of the wafer cleaning and drying system 100 in accordance with one embodiment of present invention. The system 100, in one embodiment, has the proximity head carrier assembly 104 that is configured to enable the proximity heads 106a and 106b to be moved from the center of the wafer towards the edge of the wafer. It should be appreciated that the proximity head carrier assembly 104 may be movable in any suitable manner that would enable movement of the proximity heads 106a and 106b to clean and/or dry the wafer as desired. In one embodiment, the proximity head carrier assembly 104 can be motorized to move the proximity head 106a and 106b from the center of the wafer to the edge of the wafer. It should be understood that although the wafer cleaning and drying system 100 is shown with the proximity heads 106a and 106b, that any suitable number of proximity heads may be utilized such as, for example, 1, 2, 3, 4, 5,6, etc. The proximity heads 106a and/or 106b of the wafer cleaning and drying system 100 may also be any suitable size or shape as shown by, for example, the proximity heads 106, 106-1, 106-2, 106-3, 106-4, 106-5, 106-6, 106-7 which are discussed in reference to Figures 6 through 15. The different configurations described herein generate a fluid meniscus between the proximity head and the wafer. The fluid meniscus may be moved across the wafer to clean and dry the wafer by applying fluid to the wafer surface and removing the fluids from the surface. Therefore, the proximity heads 106a and 106b can have any numerous types of configurations as shown herein or other configurations that enable the processes described herein. It should also be appreciated that the system 100 may clean and dry one surface of the wafer or both the top surface and the bottom surface of the wafer.

In addition, besides cleaning or drying both the top and bottom surfaces and of the wafer, the system 100 may also be configured to clean one side of the wafer and dry another side of the wafer if desired by inputting and outputting different types of fluids. It should be appreciated that the system 100 may utilize the application of different chemicals top and bottom in the proximity heads 106a and 106b respectively depending on the operation desired. The proximity heads can be configured to clean and dry the bevel edge of the wafer in addition to cleaning and/or drying the top and/or bottom of the wafer. This can be accomplished by moving the meniscus off the edge the wafer which cleans the bevel edge. It should also be understood that the proximity heads 106a and 106b may be the same type of head or different types of heads.

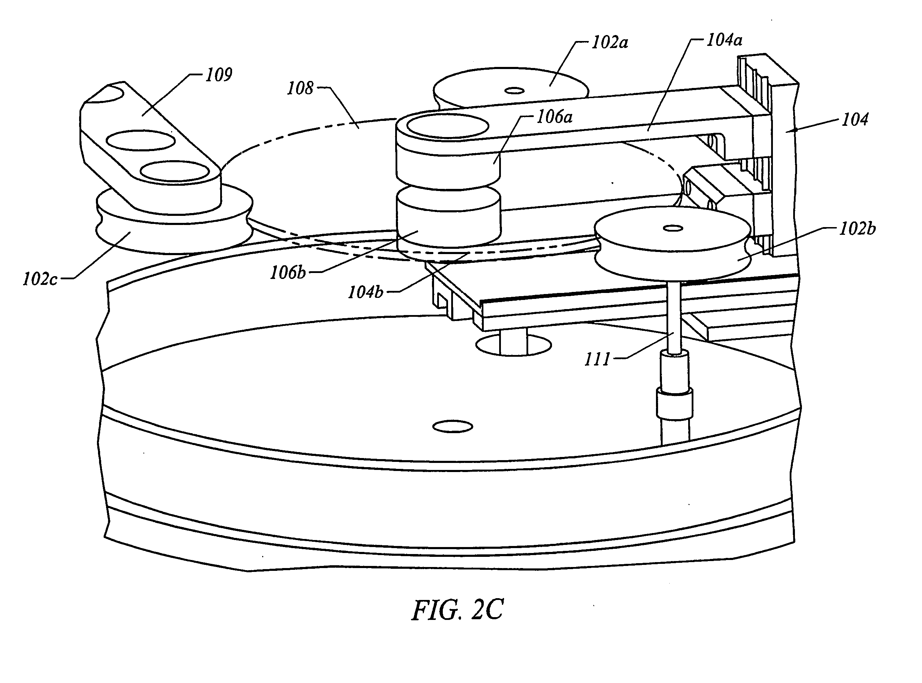

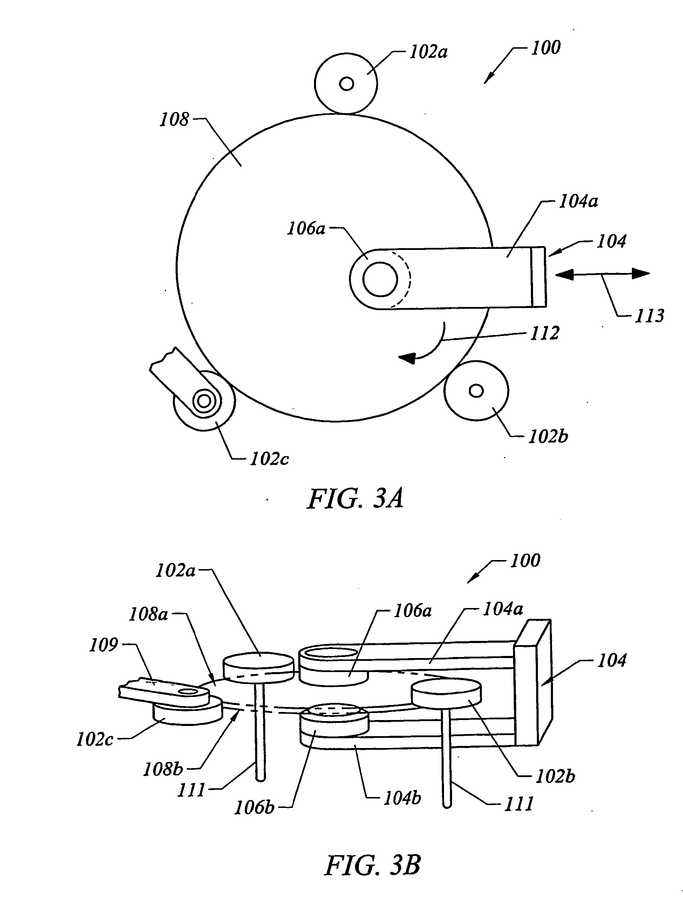

Figure 2C illustrates a side close-up view of the wafer cleaning and drying system 100 holding a wafer 108 in accordance with one embodiment of the present invention. The wafer 108 may be held and rotated by the rollers 102a, 102b, and 102c in any suitable orientation as long as the orientation enables a desired proximity head to be in close proximity to a portion of the wafer 108 that is to be cleaned or dried. In one embodiment, the roller 102b may be rotated by using a spindle 111, and the roller 102c may held and rotated by a roller arm 109. The roller 102a may also be rotated by its own spindle (as shown in Figure 3B. In one embodiment, the rollers 102a, 102b, and 102c can rotate in a clockwise direction to rotate the wafer 108 in a counterclockwise direction. It should be understood that the rollers may be rotated in either a clockwise or a counterclockwise direction depending on the wafer rotation desired. In one embodiment, the rotation imparted on the wafer 108 by the rollers 102a, 102b, and 102c serves to move a wafer area that has not been processed into close proximity to the proximity heads 106a and 106b. However, the rotation itself does not dry the wafer or move fluid on the wafer surfaces towards the edge of the wafer. Therefore, in an exemplary drying operation, the wet areas of the wafer would be presented to the proximity heads 106a and 106b through both the linear motion of the proximity heads 106a and 106b and through the rotation of the wafer 108. The drying or cleaning operation itself is conducted by at least one of the proximity heads. Consequently, in one embodiment, a dry area of the wafer 108 would expand from a center region to the edge region of the wafer 108 in a spiral movement as a drying operation progresses. By changing the configuration of the system 100 and the orientation of and movement of the proximity head 106a and/or the proximity head 106b, the drying movement may be changed to accommodate nearly any suitable type of drying path.

It should be understood that the proximity heads 106a and 106b may be configured to have at least one of first source inlet configured to input deionized water (DIW) (also known as a DIW inlet), at least one of a second source inlet configured to input isopropyl alcohol (IPA) in vapor form (also known as IPA inlet), and at least one source outlet configured to output fluids from a region between the wafer and a particular proximity head by applying vacuum (also known as vacuum outlet). It should be appreciated that the vacuum utilized herein may also be suction. In addition, other types of solutions may be inputted into the first source inlet and the second source inlet such as, for example, cleaning solutions, ammonia, HF, etc. It should be appreciated that although IPA vapor is used in some of the exemplary embodiments, any other type of vapor may be utilized such as for example, nitrogen, any suitable alcohol vapor, organic compounds, etc. that may be miscible with water.

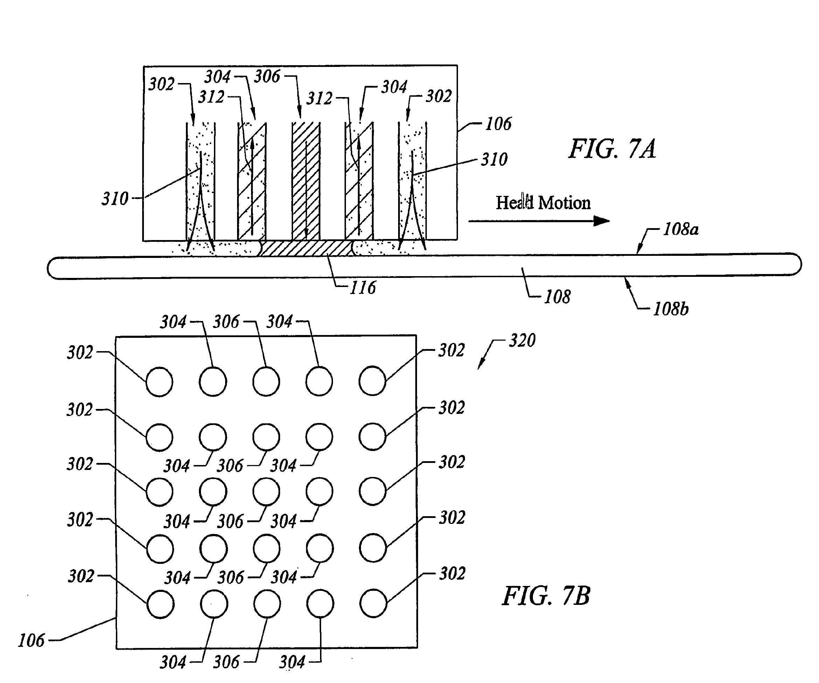

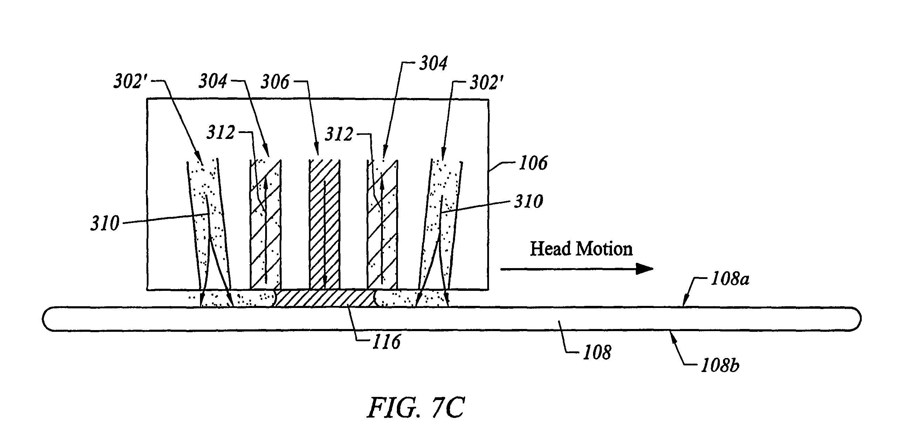

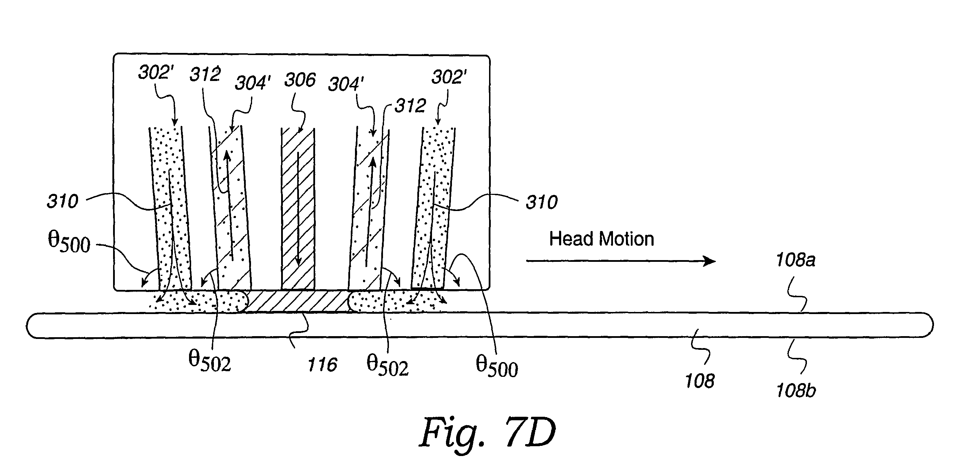

In one embodiment, the at least one IPA vapor inlet is adjacent to the at least one vacuum outlet which is in turn adjacent to the at least one DIW inlet to form an IPA-vacuum-DIW orientation. It should be appreciated that other types of orientations such as IPA-DIW-vacuum, DIW-vacuum-IPA, vacuum-IPA-DIW, etc. may be utilized depending on the wafer processes desired and what type of wafer cleaning and drying mechanism is sought to be enhanced. In a preferable embodiment, the IPA-vacuum-DIW orientation may be utilized to intelligently and powerfully generate, control, and move the meniscus located between a proximity head and a wafer to clean and dry wafers. The DIW inlets, the IPA vapor inlets, and the vacuum outlets may be arranged in any suitable manner if the above orientation is maintained. For example, in addition to the IPA vapor inlet, the vacuum outlet, and the DIW inlet, in an additional embodiment, there may be additional sets of IPA vapor outlets, DIW inlets and/or vacuum outlets depending on the configuration of the proximity head desired. Therefore, another embodiment may utilize an IPA-vacuum-DIW-DIW-vacuum-IPA or other exemplary embodiments with an IPA source inlet, vacuum source outlet, and DIW source inlet configurations are described in reference to Figures 7 to 15 with a preferable embodiment being described in reference to Figure 6D.

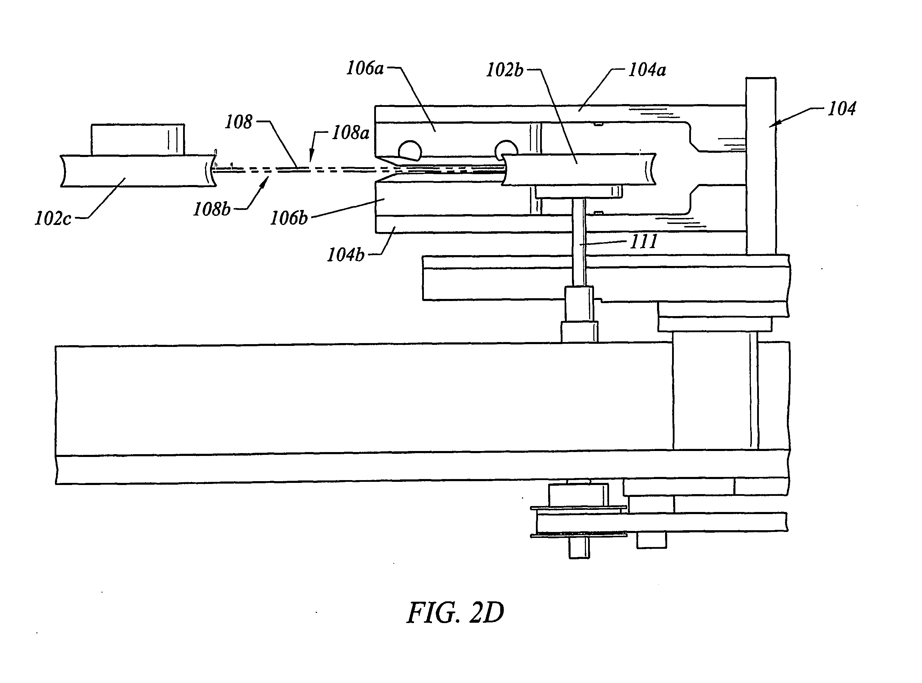

Figure 2D shows another side close-up view of the wafer cleaning and drying system 100 in accordance with one embodiment of the present invention. In this embodiment, the proximity heads 106a and 106b have been positioned in close proximity to a top surface 108a and a bottom surface 108b of the wafer 108 respectively by utilization of the proximity head carrier assembly 104. Once in this position, the proximity heads 106a and 106b may utilize the IPA and DIW source inlets and a vacuum source outlet(s) to generate wafer processing meniscuses in contact with the wafer 108 which are capable of removing fluids from a top surface 108a and a bottom surface 108b. The wafer processing meniscus may be generated in accordance with the descriptions in reference to Figures 6 through 9B where IPA vapor and DIW are inputted into the region between the wafer 108 and the proximity heads 106a and 106b. At substantially the same time the IPA and DIW is inputted, a vacuum may be applied in close proximity to the wafer surface to output the IPA vapor, the DIW, and the fluids that may be on a wafer surface. It should be appreciated that although IPA is utilized in the exemplary embodiment, any other suitable type of vapor may be utilized such as for example, nitrogen, any suitable alcohol vapor, organic compounds, hexanol, ethyl glycol, etc. that may be miscible with water. The portion of the DIW that is in the region between the proximity head and the wafer is the meniscus. It should be appreciated that as used herein, the term "output" can refer to the removal of fluid from a region between the wafer 108 and a particular proximity head, and the term "input" can be the introduction of fluid to the region between the wafer 108 and the particular proximity head.

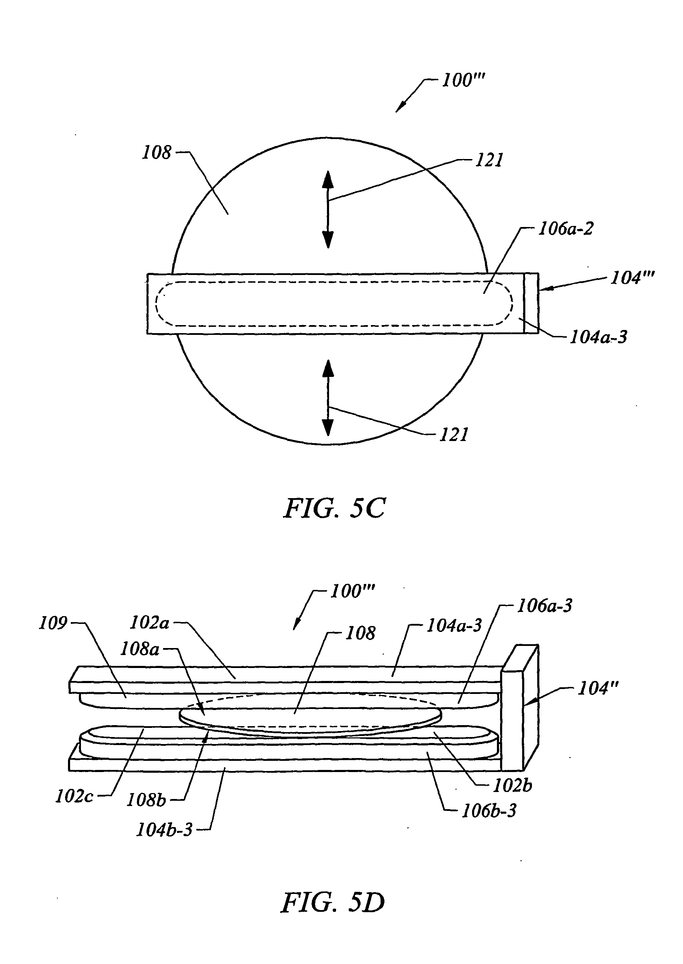

In another exemplary embodiment, the proximity heads 106a and 106b may be moved in a manner so all parts of the wafer 108 are cleaned, dried, or both without the wafer 108 being rotated. In such an embodiment, the proximity head carrier assembly 104 may be configured to enable movement of the either one or both of the proximity heads 106a and 106b to close proximity of any suitable region of the wafer 108. In one embodiment, the proximity heads may be configured to move in a spiral manner from the center to the edge of the wafer 108 or vice versa. In another embodiment, the proximity heads 104a and 104b may be configured to move in a linear fashion back and forth across the wafer 108 so all parts of the wafer surfaces 108a and/or 108b may be processed. In yet another embodiment, a configuration as discussed below in reference to Figure 5C through 5F may be utilized. Consequently, countless different configurations of the system 100 may be utilized in order to obtain an optimization of the wafer processing operation.

Figure 3A shows a top view illustrating the wafer cleaning and drying system 100 with dual proximity heads in accordance with one embodiment of the present invention. As described above in reference to Figures 2A to 2D, the upper arm 104a may be configured to move and hold the proximity head 106a in a position in close proximity over the wafer 108. The upper arm 104a may also be configured to move the proximity head 106a from a center portion of the wafer 108 towards the edge of the wafer 108 in a substantially linear fashion 113. Consequently, in one embodiment, as the wafer 108 moves as shown by rotation 112, the proximity head 106a is capable of removing a fluid film from the top surface 108a of the wafer 108 using a process described in further detail in reference to Figures 6 through 8. Therefore, the proximity head 106a may dry the wafer 108 in a substantially spiral path over the wafer 108. In another embodiment as shown in reference to Figure 3B, there may be a second proximity head located below the wafer 108 to remove a fluid film from the bottom surface 108b of the wafer 108.

Figure 3B illustrates a side view of the wafer cleaning and drying system 100 with dual proximity heads in accordance with one embodiment of the present invention. In this embodiment, the system 100 includes both the proximity head 106a capable of processing a top surface of the wafer 108 and the proximity head 106b capable of processing a bottom surface of the wafer 108. In one embodiment, spindles 111a and 111b along with a roller arm 109 may rotate the rollers 102a, 102b, and 102c respectively. This rotation of the rollers 102a, 102b, and 102c may rotate the wafer 108 so substantially all surfaces of the wafer 108 may be presented to the proximity heads 106a and 106b for drying and/or cleaning. In one embodiment, while the wafer 108 is being rotated, the proximity heads 106a and 106b are brought to close proximity of the wafer surfaces 108a and 108b by the arms 104a and 104b respectively. Once the proximity heads 106a and 106b are brought into close proximity to the wafer 108, the wafer drying or cleaning may be begun. In operation, the proximity heads 106a and 106b may each remove fluids from the wafer 108 by applying IPA, deionized water and vacuum to the top surface and the bottom surface of the wafer 108 as described in reference to Figure 6.

In one embodiment, by using the proximity heads 106a and 106b, the system 100 may dry a 200 mm wafer in less than 3 minutes. It should be understood that drying or cleaning time may be decreased by increasing the speed at which the proximity heads 106a and 106b travels from the center of the wafer 108 to the edge of the wafer 108. In another embodiment, the proximity heads 106a and 106b may be utilized with a faster wafer rotation to dry the wafer 108 in less time. In yet another embodiment, the rotation of the wafer 108 and the movement of the proximity heads 106a and 106b may be adjusted in conjunction to obtain an optimal drying/cleaning speed. In one embodiment, the proximity heads 106a and 106b may move linearly from a center region of the wafer 108 to the edge of the wafer 108 at between about 5 mm per minute to about 500 mm per minute.

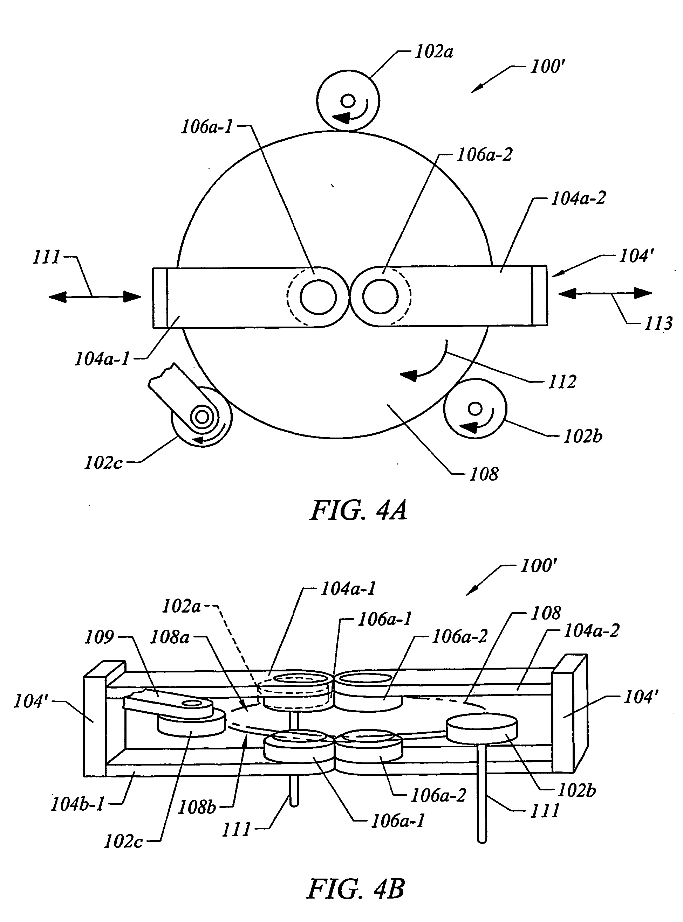

Figure 4A shows a top view of a wafer cleaning and drying system 100' which includes multiple proximity heads for a particular surface of the wafer 108 in accordance with one embodiment of the present invention. In this embodiment, the system 100' includes an upper arm 104a-1 and an upper arm 104a-2. As shown in Figure 4B, the system 100' also may include lower arm 104b-1 and lower arm 104b-2 connected to proximity heads 106b-1 and 106b-2 respectively. In the system 100', the proximity heads 106a-1 and 106a-2 (as well as 106b-1 and 106b-2 if top and bottom surface processing is being conducted) work in conjunction so, by having two proximity heads processing a particular surface of the wafer 108, drying time or cleaning time may be cut to about half of the time. Therefore, in operation, while the wafer 108 is rotated, the proximity heads 106a-1, 106a-2, 106b-1, and 106b-2 start processing the wafer 108 near the center of the wafer 108 and move outward toward the edge of the wafer 108 in a substantially linear fashion. In this way, as the rotation 112 of the wafer 108 brings all regions of the wafer 108 in proximity with the proximity heads so as to process all parts of the wafer 108. Therefore, with the linear movement of the proximity heads 106a-1, 106a-2, 106b-1, and 106b-2 and the rotational movement of the wafer 108, the wafer surface being dried moves in a spiral fashion from the center of the wafer 108 to the edge of the wafer 108.

In another embodiment, the proximity heads 106a-1 and 106b-1 may start processing the wafer 108 and after they have moved away from the center region of the wafer 108, the proximity heads 106a-2 and 106b-2 may be moved into place in the center region of the wafer 108 to augment in wafer processing operations. Therefore, the wafer processing time may be decreased significantly by using multiple proximity heads to process a particular wafer surface.

Figure 4B shows a side view of the wafer cleaning and drying system 100' which includes multiple proximity heads for a particular surface of the wafer 108 in accordance with one embodiment of the present invention. In this embodiment, the system 100' includes both the proximity heads 106a-1 and 106a-2 that are capable of processing the top surface 108a of the wafer 108, and proximity heads 106b-1 and 106b-2 capable of processing the bottom surface 108b of the wafer 108. As in the system 100, the spindles 111a and 111b along with a roller arm 109 may rotate the rollers 102a, 102b, and 102c respectively. This rotation of the rollers 102a, 102b, and 102c may rotate the wafer 108 so substantially all surfaces of the wafer 108 may brought in close proximity to the proximity heads 106a-1, 106a-2, 106b-1, and 106b-2 for wafer processing operations.

In operation, each of the proximity heads 106a-1, 106a-2, 106b-1, and 106b-2 may remove fluids from the wafer 108 by applying IPA, deionized water and vacuum to the top surface and the bottom surface of the wafer 108 as shown, for example, in Figure 6 through 8. By having two proximity heads per wafer side, the wafer processing operation (i.e., cleaning and/or drying) may be accomplished in substantially less time. It should be appreciated that as with the wafer processing system described in reference to Figure 3A and 3B, the speed of the wafer rotation may be varied to any suitable speed as long as the configuration enables proper wafer processing. In one embodiment, the wafer processing time may be decreased when half a rotation of the wafer 108 is used to dry the entire wafer. In such an embodiment, the wafer processing speed may be about half of the processing speed when only one proximity head is utilized per wafer side.

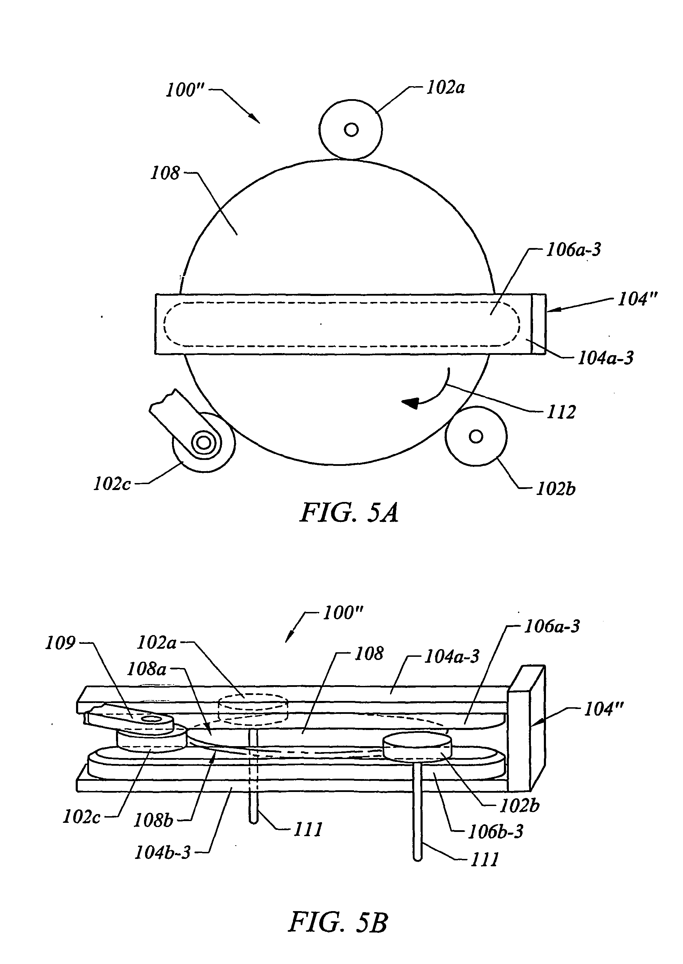

Figure 5A shows a top view of a wafer cleaning and drying system 100" with a proximity head 106a-3 in a horizontal configuration which extends across a diameter of the wafer 108 in accordance with one embodiment of the present invention. In this embodiment, the proximity head 106a-3 is held by an upper arm 104a-3 that extends across a diameter of the wafer 108. In this embodiment, the proximity head 106a-3 may be moved into a cleaning/drying position by a vertical movement of the upper arm 104a-3 so the proximity head 106a-3 can be in a position that is in close proximity to the wafer 108. Once the proximity head 106a-3 is in close proximity to the wafer 108, the wafer processing operation of a top surface of the wafer 108 can take place.

Figure 5B shows a side view of a wafer cleaning and drying system 100" with the proximity heads 106a-3 and 106b-3 in a horizontal configuration which extends across a diameter of the wafer 108 in accordance with one embodiment of the present invention. In this embodiment, the proximity head 106a-3 and the proximity head 106b-3 both are elongated to be able to span the diameter of the wafer 108. In one embodiment, while the wafer 108 is being rotated, the proximity heads 106a-3 and 106b-3 are brought to close proximity of the wafer surfaces 108a and 108b by the top arm 104a and a bottom arm 106b-3 respectively. Because the proximity heads 106a-3 and 106b-3 extend across the wafer 108, only half of a full rotation may be needed to clean/dry the wafer 108.

Figure 5C shows a top view of a wafer cleaning and drying system 100"' with the proximity heads 106a-3 and 106b-3 in a horizontal configuration which is configured to clean and/or dry the wafer 108 that is stationary in accordance with one embodiment of the present invention. In this embodiment, the wafer 108 may be held stationary by any suitable type of wafer holding device such as, for example, an edge grip, fingers with edge attachments, etc. The proximity head carrier assembly 104"' is configured to be movable from one edge of the wafer 108 across the diameter of the wafer 108 to an edge on the other side of the wafer 108 after crossing the entire wafer diameter. In this fashion, the proximity head 106a-3 and/or the proximity head 106b-3 (as shown below in reference to Figure 5D) may move across the wafer following a path along a diameter of the wafer 108 from one edge to an opposite edge. It should be appreciated that the proximity heads 106a-3 and/or 106b-3 may be move from any suitable manner that would enable moving from one edge of the wafer 108 to another diametrically opposite edge. In one embodiment, the proximity head 106a-3 and/or the proximity head 106b-3 may move in directions 121 (e.g., top to bottom or bottom to top of Figure 5C). Therefore, the wafer 108 may stay stationary without any rotation or movement and the proximity heads 106a-3 and/or the proximity head 106b-3 may move into close proximity of the wafer and, through one pass over the wafer 108, clean/dry the top and/or bottom surface of the wafer 108.

Figure 5D shows a side view of a wafer cleaning and drying system 100"' with the proximity heads 106a-3 and 106b-3 in a horizontal configuration which is configured to clean and/or dry the wafer 108 that is stationary in accordance with one embodiment of the present invention. In this embodiment, the proximity head 106a-3 is in a horizontal position with the wafer 108 also in a horizontal position. By use of the proximity head 106a-3 and the proximity head 106b-3 that spans at least the diameter of the wafer 108, the wafer 108 may be cleaned and/or dried in one pass by moving proximity heads 106a-3 and 106b-3 in the direction 121 as discussed in reference to Figure 5C.

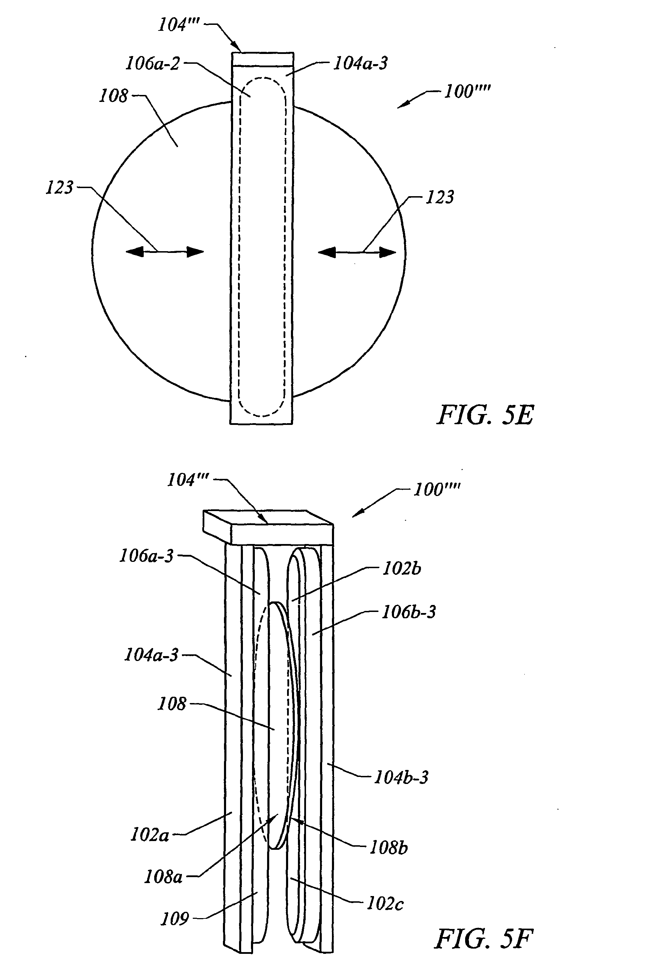

Figure 5E shows a side view of a wafer cleaning and drying system 100"" with the proximity heads 106a-3 and 106b-3 in a vertical configuration enabled to clean and/or dry the wafer 108 that is stationary in accordance with one embodiment of the present invention. In this embodiment, the proximity heads 106a-3 and 106b-3 are in a vertical configuration, and the proximity heads 106a-3 and 106b-3 are configured to move either from left to right, or from right to left, beginning from a first edge of the wafer 108 to a second edge of the wafer 108 that is diametrically opposite to the first edge. Therefore, in such as embodiment, the proximity head carrier assembly 104"' may move the proximity heads 104a-3 and 104b-3 in close proximity with the wafer 108 and also enable the movement of the proximity heads 104a-3 and 104b-3 across the wafer from one edge to another so the wafer 108 may be processed in one pass thereby decreasing the time to clean and/or dry the wafer 108.

Figure 5F shows an alternate side view of a wafer cleaning and drying system 100"" that is shifted 90 degrees from the side view shown in Figure 5E in accordance with one embodiment of the present invention. It should be appreciated that the proximity head carrier assembly 104"' may be oriented in any suitable manner such as for example, having the proximity head carrier assembly 104"' rotated 180 degrees as compared with what is shown in Figure 5F.

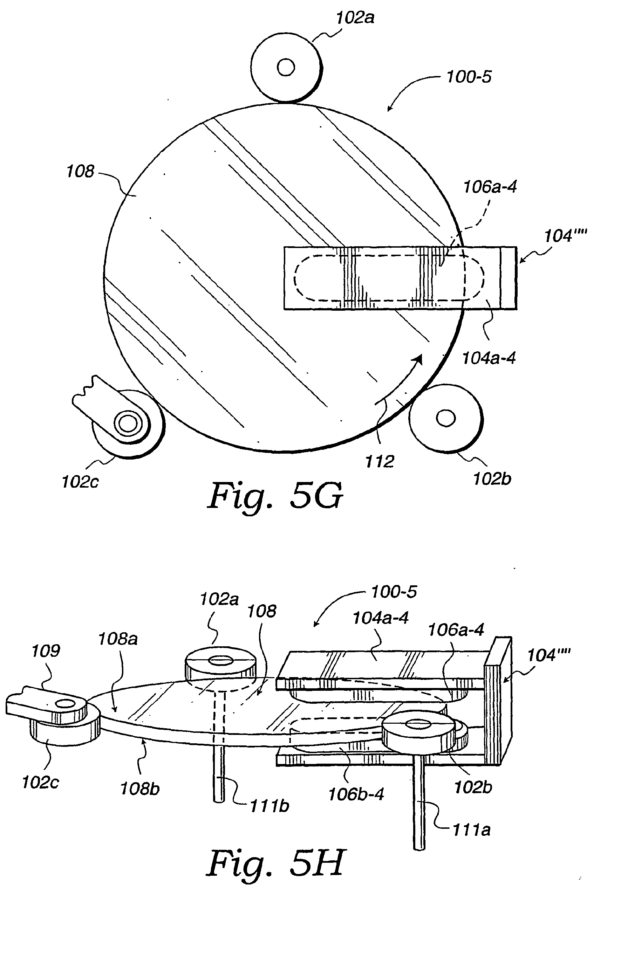

Figure 5G shows a top view of a wafer cleaning and drying system 100-5 with a proximity head 106a-4 in a horizontal configuration which extends across a radius of the wafer 108 in accordance with one embodiment of the present invention. In one embodiment, the proximity head 106a-4 extends across less than a radius of a substrate being processed. In another embodiment, the proximity head 106a-4 may extend the radius of the substrate being processed. In a preferable embodiment, the proximity head 106a-4 extends over a radius of the wafer 108 so the proximity head may process both the center point of the wafer 108 as well as an edge of the wafer 108 so the proximity head 106a-4 can cover and process the center point of the wafer and the edge of the wafer. In this embodiment, the proximity head 106a-4 may be moved into a cleaning/drying position by a vertical movement of the upper arm 104a-4 so the proximity head 106a-4 can be in a position that is in close proximity to the wafer 108. Once the proximity head 106a-4 is in close proximity to the wafer 108, the wafer processing operation of a top surface of the wafer 108 can take place. Because, in one embodiment, the proximity head 106a-4 extends over the radius of the wafer, the wafer may be cleaned and/or dried in one rotation.

Figure 5H shows a side view of a wafer cleaning and drying system 100-5 with the proximity heads 106a-4 and 106b-4 in a horizontal configuration which extends across a radius of the wafer 108 in accordance with one embodiment of the present invention. In this embodiment, the proximity head 106a-4 and the proximity head 106b-4 both are elongated to be able to extend over and beyond the radius of the wafer 108. As discussed in reference to Figure 5G, depending on the embodiment desired, the proximity head 106a-4 may extend less than a radius, exactly a radius, or greater than a radius of the wafer 108. In one embodiment, while the wafer 108 is being rotated, the proximity heads 106a-4 and 106b-4 are brought to close proximity of the wafer surfaces 108a and 108b by the top arm 104a and a bottom arm 106b-4 respectively. Because in one embodiment, the proximity heads 106a-4and 106b-4 extend across greater than the radius of the wafer 108, only a full rotation may be needed to clean/dry the wafer 108.

Figure 6A shows a proximity head inlet/outlet orientation 117 that may be utilized to clean and dry the wafer 108 in accordance with one embodiment of the present invention. In one embodiment, the orientation 117 is a portion of a proximity head 106 where other source inlets 302 and 306 in addition to other source outlets 304 may be utilized in addition to the orientation 117 shown. The orientation 117 may include a source inlet 306 on a leading edge 109 with a source outlet 304 in between the source inlet 306 and the source outlet 302.

Figure 6B shows another proximity head inlet/outlet orientation 119 that may be utilized to clean and dry the wafer 108 in accordance with one embodiment of the present invention. In one embodiment, the orientation 119 is a portion of a proximity head 106 where other source inlets 302 and 306 in addition to other source outlets 304 may be utilized in addition to the orientation 119 shown. The orientation 119 may include a source outlet 304 on a leading edge 109 with a source inlet 302 in between the source outlet 304 and the source inlet 306.

Figure 6C shows a further proximity head inlet/outlet orientation 121 that may be utilized to clean and dry the wafer 108 in accordance with one embodiment of the present invention. In one embodiment, the orientation 121 is a portion of a proximity head 106 where other source inlets 302 and 306 in addition to other source outlets 304 may be utilized in addition to the orientation 119 shown. The orientation 119 may include a source inlet 306 on a leading edge 109 with a source inlet 302 in between the source outlet 304 and the source outlet 306.

Figure 6D illustrates a preferable embodiment of a wafer drying process that may be conducted by a proximity head 106 in accordance with one embodiment of the present invention. Although Figure 6 shows a top surface 108a being dried, it should be appreciated that the wafer drying process may be accomplished in substantially the same way for the bottom surface 108b of the wafer 108. In one embodiment, a source inlet 302 may be utilized to apply isopropyl alcohol (IPA) vapor toward a top surface 108a of the wafer 108, and a source inlet 306 may be utilized to apply deionized water (DIW) toward the top surface 108a of the wafer 108. In addition, a source outlet 304 may be utilized to apply vacuum to a region in close proximity to the wafer surface to remove fluid or vapor that may located on or near the top surface 108a. It should be appreciated that any suitable combination of source inlets and source outlets may be utilized as long as at least one combination exists where at least one of the source inlet 302 is adjacent to at least one of the source outlet 304 which is in turn adjacent to at least one of the source inlet 306. The IPA may be in any suitable form such as, for example, IPA vapor where IPA in vapor form is inputted through use of a N₂ gas. Moreover, although DIW is utilized herein, any other suitable fluid may be utilized that may enable or enhance the wafer processing such as, for example, water purified in other ways, cleaning fluids, etc. In one embodiment, an IPA inflow 310 is provided through the source inlet 302, a vacuum 312 may be applied through the source outlet 304 and DIW inflow 314 may be provided through the source inlet 306. Therefore, an embodiment of the IPA-vacuum-DIW orientation as described above in reference to Figure 2 is utilized. Consequently, if a fluid film resides on the wafer 108, a first fluid pressure may be applied to the wafer surface by the IPA inflow 310, a second fluid pressure may be applied to the wafer surface by the DIW inflow 314, and a third fluid pressure may be applied by the vacuum 312 to remove the DIW, IPA and the fluid film on the wafer surface.

Therefore, in one embodiment, as the DIW inflow 314 and the IPA inflow 310 is applied toward a wafer surface, any fluid on the wafer surface is intermixed with the DIW inflow 314. At this time, the DIW inflow 314 that is applied toward the wafer surface encounters the IPA inflow 310. The IPA forms an interface 118 (also known as an IPA/DIW interface 118) with the DIW inflow 314 and along with the vacuum 312 assists in the removal of the DIW inflow 314 along with any other fluid from the surface of the wafer 108. In one embodiment, the IPA/DIW interface 118 reduces the surface of tension of the DIW. In operation, the DIW is applied toward the wafer surface and almost immediately removed along with fluid on the wafer surface by the vacuum applied by the source outlet 304. The DIW that is applied toward the wafer surface and for a moment resides in the region between a proximity head and the wafer surface along with any fluid on the wafer surface forms a meniscus 116 where the borders of the meniscus 116 are the IPA/DIW interfaces 118. Therefore, the meniscus 116 is a constant flow of fluid being applied toward the surface and being removed at substantially the same time with any fluid on the wafer surface. The nearly immediate removal of the DIW from the wafer surface prevents the formation of fluid droplets on the region of the wafer surface being dried thereby reducing the possibility of contamination drying on the wafer 108. The pressure (which is caused by the flow rate of the IPA) of the downward injection of IPA also helps contain the meniscus 116.

The flow rate of the IPA assists in causing a shift or a push of water flow out of the region between the proximity head and the wafer surface and into the source outlets 304 through which the fluids may be outputted from the proximity head. Therefore, as the IPA and the DIW is pulled into the source outlets 304, the boundary making up the IPA/DIW interface 118 is not a continuous boundary because gas (e.g., air) is being pulled into the source outlets 304 along with the fluids. In one embodiment, as the vacuum from the source outlet 304 pulls the DIW, IPA, and the fluid on the wafer surface, the flow into the source outlet 304 is discontinuous. This flow discontinuity is analogous to fluid and gas being pulled up through a straw when a vacuum is exerted on combination of fluid and gas. Consequently, as the proximity head 106 moves, the meniscus moves along with the proximity head, and the region previously occupied by the meniscus has been dried due to the movement of the IPA/DIW interface 118. It should also be understood that the any suitable number of source inlets 302, source outlets 304 and source inlets 306 may be utilized depending on the configuration of the apparatus and the meniscus size and shape desired. In another embodiment, the liquid flow rates and the vacuum flow rates are such that the total liquid flow into the vacuum outlet is continuous, so no gas flows into the vacuum outlet.

It should be appreciated any suitable flow rate may be utilized for the IPA, DIW, and vacuum as long as the meniscus 116 can be maintained. In one embodiment, the flow rate of the DIW through a set of the source inlets 306 is between about 25 ml per minute to about 3,000 ml per minute. In a preferable embodiment, the flow rate of the DIW through the set of the source inlets 306 is about 400 ml per minute. It should be understood that the flow rate of fluids may vary depending on the size of the proximity head. In one embodiment a larger head may have a greater rate of fluid flow than smaller proximity heads. This may occur because larger proximity heads, in one embodiment, have more source inlets 302 and 306 and source outlets 304 More flow for larger head.

In one embodiment, the flow rate of the IPA vapor through a set of the source inlets 302 is between about 1 standard cubic feet per minute (SCFM) to about 100 SCFM. In a preferable embodiment, the IPA flow rate is between about 10 and 40 SCFM.

In one embodiment, the flow rate for the vacuum through a set of the source outlets 304 is between about 10 standard cubic feet per hour (SCFH) to about 1250 SCFH. In a preferable embodiment, the flow rate for a vacuum though the set of the source outlets 304 is about 350 SCFH. In an exemplary embodiment, a flow meter may be utilized to measure the flow rate of the IPA, DIW, and the vacuum.

Figure 6E shows another wafer drying process using another source inlet/outlet orientation that may be conducted by a proximity head 106 in accordance with one embodiment of the present invention. In this embodiment, the proximity head 106 may be moved over the top surface 108a of the wafer 108 so the meniscus may be moved along the wafer surface 108a. The meniscus applies fluid to the wafer surface and removes fluid from the wafer surface thereby cleaning and drying the wafer simultaneously. In this embodiment, the source inlet 306 applies a DIW flow 314 toward the wafer surface 108a, the source inlet 302 applies IPA flow 310 toward the wafer surface 108a, and the source outlet 312 removes fluid from the wafer surface 108a. It should be appreciated that in this embodiment as well as other embodiments of the proximity head 106 described herein, additional numbers and types of source inlets and source outlets may be used in conjunction with the orientation of the source inlets 302 and 306 and the source outlets 304 shown in Figure 6E. In addition, in this embodiment as well as other proximity head embodiments, by controlling the amount of flow of fluids onto the wafer surface 108a and by controlling the vacuum applied, the meniscus may be managed and controlled in any suitable manner. For example, in one embodiment, by increasing the DIW flow 314 and/or decreasing the vacuum 312, the outflow through the source outlet 304 may be nearly all DIW and the fluids being removed from the wafer surface 108a. In another embodiment, by decreasing the DIW flow 314 and/or increasing the vacuum 312; the outflow through the source outlet 304 may be substantially a combination of DIW and air as well as fluids being removed from the wafer surface 108a.

Figure 6F shows another source inlet and outlet orientation where an additional source outlet 307 may be utilized to input an additional fluid in accordance with one embodiment of the present invention. The orientation of inlets and outlets as shown in Figure 6E is the orientation described in further detail in reference to Figure 6D except the additional source outlet 307 is included adjacent to the source inlet 306 on a side opposite that of the source outlet 304. In such an embodiment, DIW may be inputted through the source inlet 306 while a different solution such as, for example, a cleaning solution may be inputted through the source inlet 307. Therefore, a cleaning solution flow 315 may be utilized to enhance cleaning of the wafer 108 while at substantially the same time drying the top surface 108a of the wafer 108.

Figure 7A illustrates a proximity head 106 performing a drying operation in accordance with one embodiment of the present invention. The proximity head 106, in one embodiment, moves while in close proximity to the top surface 108a of the wafer 108 to conduct a cleaning and/or drying operation. It should be appreciated that the proximity head 106 may also be utilized to process (e.g., clean, dry, etc.) the bottom surface 108b of the wafer 108. In one embodiment, the wafer 108 is rotating so the proximity head 106 may be moved in a linear fashion along the head motion while fluid is removed from the top surface 108a. By applying the IPA 310 through the source inlet 302, the vacuum 312 through source outlet 304, and the deionized water 314 through the source inlet 306, the meniscus 116 as discussed in reference to Figure 6 may be generated.

Figure 7B shows a top view of a portion of a proximity head 106 in accordance with one embodiment of the present invention. In the top view of one embodiment, from left to right are a set of the source inlet 302, a set of the source outlet 304, a set of the source inlet 306, a set of the source outlet 304, and a set of the source inlet 302. Therefore, as IPA and DIW are inputted into the region between the proximity head 106 and the wafer 108, the vacuum removes the IPA and the DIW along with any fluid film that may reside on the wafer 108. The source inlets 302, the source inlets 306, and the source outlets 304 described herein may also be any suitable type of geometry such as for example, circular opening, square opening, etc. In one embodiment, the source inlets 302 and 306 and the source outlets 304 have circular openings.

Figure 7C illustrates a proximity head 106 with angled source inlets 302' performing a drying operation in accordance with one embodiment of the present invention. It should be appreciated that the source inlets 302' and 306 and the source outlet(s) 304 described herein may be angled in any suitable way to optimize the wafer cleaning and/or drying process. In one embodiment, the angled source inlets 302' that input IPA vapor onto the wafer 108 is angled toward the source inlets 306 such that the IPA vapor flow is directed to contain the meniscus 116.

Figure 7D illustrates a proximity head 106 with angled source inlets 302' and angled source outlets 304' performing a drying operation in accordance with one embodiment of the present invention. It should be appreciated that the source inlets 302' and 306 and the angled source outlet(s) 304' described herein may be angled in any suitable way to optimize the wafer cleaning and/or drying process.

In one embodiment, the angled source inlets 302' that input IPA vapor onto the wafer 108 is angled at an angle θ₅₀₀ toward the source inlets 306 such that the IPA vapor flow is directed to contain the meniscus 116. The angled source outlet 304' may, in one embodiment, be angled at an angle θ₅₀₀ towards the meniscus 116. It should be appreciated that the angle θ₅₀₀ and the angle θ₅₀₂ may be any suitable angle that would optimize the management and control of the meniscus 116. In one embodiment, the angle θ₅₀₀ is greater than 0 degrees and less than 90 degrees, and the angle θ₅₀₂ is greater than 0 degrees and less than 90 degrees. In a preferable embodiment, the angle θ₅₀₀ is about 15 degrees, and in another preferable embodiment, the angle angled at an angle θ₅₀₂ is about 15 degrees. The angle θ₅₀₀ and the angle θ₅₀₂ adjusted in any suitable manner to optimize meniscus management. In one embodiment, the angle θ₅₀₀ and the angle θ₅₀₂ may be the same, and in another embodiment, the angle θ₅₀₀ and the angle θ₅₀₂ may be different. By angling the angled source inlet(s) 302' and/or angling the angled source outlet(s) 304', the border of the meniscus may be more clearly defined and therefore control the drying and/or cleaning the surface being processed.

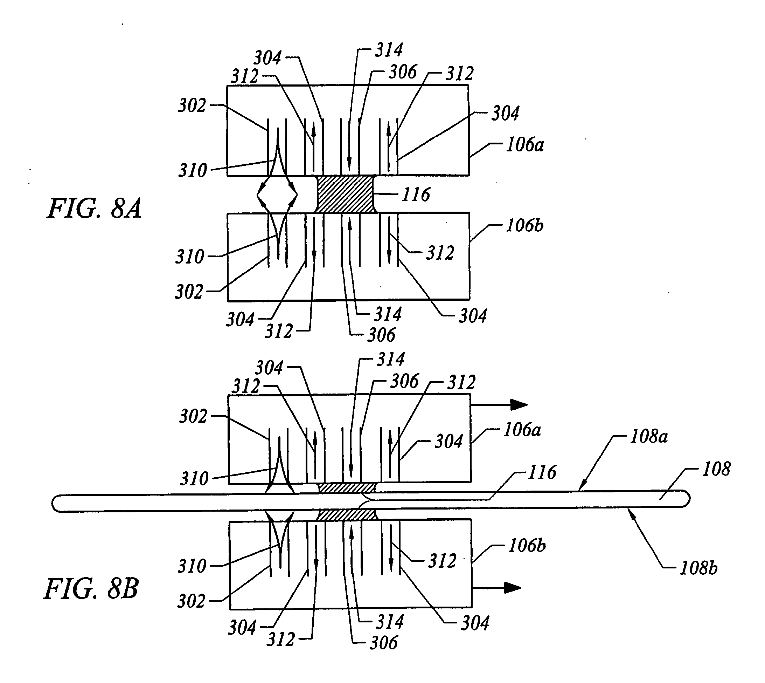

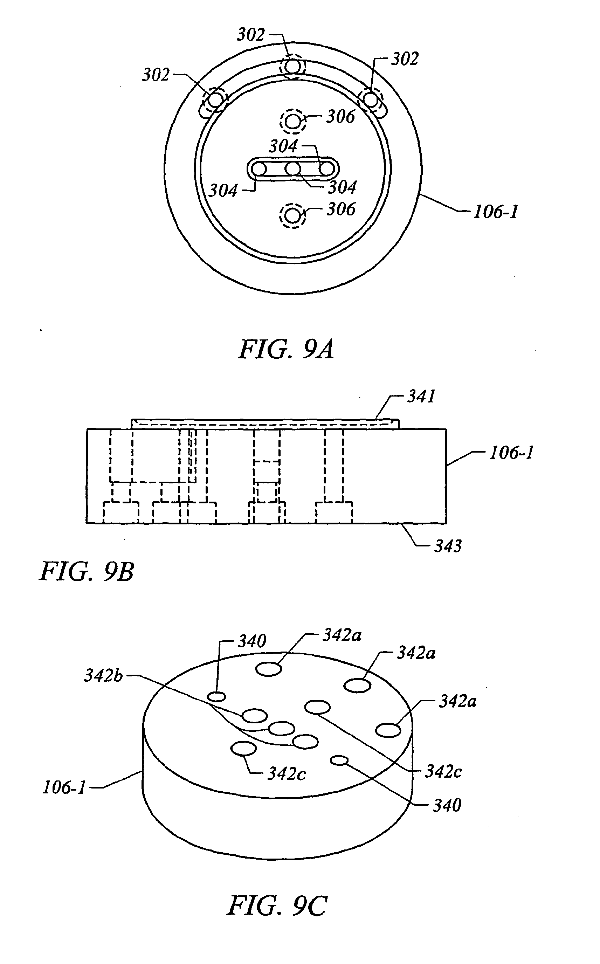

Figure 8A illustrates a side view of the proximity heads 106a and 106b for use in a dual wafer surface cleaning and drying system in accordance with one embodiment of the present invention. In this embodiment, by usage of source inlets 302 and 306 to input IPA and DIW respectively along with the source outlet 304 to provide a vacuum, the meniscus 116 may be generated. In addition, on the side of the source inlet 306 opposite that of the source inlet 302, there may be a source outlet 304 to remove DIW and to keep the meniscus 116 intact. As discussed above, in one embodiment, the source inlets 302 and 306 may be utilized for IPA inflow 310 and DIW inflow 314 respectively while the source outlet 304 may be utilized to apply vacuum 312. It should be appreciated that any suitable configuration of source inlets 302, source outlets 304 and source inlets 306 may be utilized. For example, the proximity heads 106a and 106b may have a configuration of source inlets and source outlets like the configuration described above in reference to Figure 7A and 7B. In addition, in yet more embodiments, the proximity heads 106a and 106b may be of a configuration as shown below in reference to Figures 9 through 15. Any suitable surface coming into contact with the meniscus 116 may be dried by the movement of the meniscus 116 into and away from the surface.

Figure 8B shows the proximity heads 106a and 106b in a dual wafer surface cleaning and drying system in accordance with one embodiment of the present invention. In this embodiment, the proximity head 106a processes the top surface 108a of the wafer 108, and the proximity head 106b processes the bottom surface of 108b of the wafer 108. By the inputting of the IPA and the DIW by the source inlets 302 and 306 respectively, and by use of the vacuum from the source outlet 304, the meniscus 116 may be formed between the proximity head 106a and the wafer 108 and between the proximity head 106b and the wafer 108. The proximity heads 106a and 106b, and therefore the meniscus 116, may be moved over the wet areas of the wafer surface in an manner so the entire wafer 108 can be dried.

Figures 9 through 15 illustrate exemplary embodiments of the proximity head 106. As shown by the exemplary figures that follow, the proximity head may be any suitable configuration or size that may enable the fluid removal process as described in Figures 6 to 8. Therefore, any, some, or all of the proximity heads described herein may be utilized in any suitable wafer cleaning and drying system such as, for example, the system 100 or a variant thereof as described in reference to Figures 2A to 2D. In addition, the proximity head may also have any suitable numbers or shapes of source outlets 304 and source inlets 302 and 306. It should be appreciated that the side of the proximity heads shown from a top view is the side that comes into close proximity with the wafer to conduct wafer processing. All of the proximity heads described in Figures 9 through 15 enable usage of the IPA-vacuum-DIW orientation of a variant thereof as described above in reference to Figures 2 and 6. In addition, the proximity heads described herein may be utilized for either cleaning or drying operations depending on the fluid that is inputted and outputted from the source inlets 302 and 306, and the source outlets 304. In addition, the proximity heads described herein may have multiple inlet lines and multiple outlet lines with the ability to control the relative flow rates of liquid and/or vapor and/or gas through the outlets and inlets. It should be appreciated that every group of source inlets and source outlets can have independent control of the flows.

It should be appreciated that the size as well as the locations of the source inlets and outlets may be varied as long as the meniscus produced is stable. In one embodiment, the size of the openings to source inlets 302, source outlets 304, and source inlets 306 are between about 0.02 inch and about 0.25 inch in diameter. In a preferable embodiment, the size of the openings of the source inlets 302 and the source outlets 304 is about 0.03 inch, and the size of the openings of the source inlets 306 is about 0.06 inch.

In one embodiment the source inlets 302 and 306 in addition to the source outlets 304 are spaced about 0.03 inch and about 0.5 inch apart. In a preferable embodiment, the source inlets 306 are spaced 0.125 inch apart from each other and the source outlets 304 are spaced 0.03 inch apart and the source inlets 302 are spaced about 0.03 inch apart.

Figure 9A shows a top view of a proximity head 106-1 with a circular shape in accordance with one embodiment of the present invention. In this embodiment, the proximity head 106-1 includes three of the source inlets 302 which, in one embodiment, applies IPA to a surface of the wafer 108. The proximity head 106-1 also includes three of the source outlets 304 in a center portion of the head 106-1. In one embodiment, one of the source inlets 306 is located adjacent to the source inlets 302 and the source outlets 304. In this embodiment, another one the source inlets 306 is located on the other side of the source outlets 304.

In this embodiment, the proximity head 106-1 shows that the three source outlets 304 are located in the center portion and is located within an indentation in the top surface of the proximity head 106-1. In addition, the source inlets 302 are located on a different level than the source inlets 306. The side of the proximity head 106-1 is the side that comes into close proximity with the wafer 108 for cleaning and/or drying operations.

Figure 9B shows a side view of the proximity head 106-1 with a circular shape in accordance with one embodiment of the present invention. The proximity head 106-1 has inputs at a bottom portion 343 which lead to the source inlets 302 and 306 and the source outlets 304 as discussed in further detail in reference to Figure 9C. In one embodiment, a top portion 341 of the proximity head 106-1 is smaller in circumference than the bottom portion 343. As indicated previously, it should be appreciated that the proximity head 106-1 as well as the other proximity heads described herein may have any suitable shape and/or configuration.

Figure 9C illustrates a bottom view of the proximity head 106-1 with a circular shape in accordance with one embodiment of the present invention. The proximity head 106-1 also includes ports 342a, 342b, and 342c that, in one embodiment, correspond to the source inlet 302, source outlet 304, and source inlet 306 respectively. By inputting or removing fluid through the ports 342a, 342b, and 342c, fluids may be inputted or outputted through the source inlet 302, the source outlet 304, and the source inlet 306 as discussed in reference to Figure 9A.

It should be appreciated that the ports 342a, 342b, and 342c for any of the proximity heads described herein may be any suitable orientation and dimension as long as a stable meniscus can be generated and maintained by the source inlets 302, source outlets 304, and source inlets 306. The embodiments of the ports 342a, 342b, and 342c described herein may be applicable to any of the proximity heads described herein. In one embodiment, the port size of the ports 342a, 342b, and 342c may be between about 0.03 inch and about 0.25 inch in diameter. In a preferable embodiment, the port size is about 0.06 inch to 0.18 inch in diameter. In one embodiment, the distance between the ports is between about 0.125 inch and about 1 inch apart. In a preferable embodiment, the distance between the ports is between about 0.25 inch and about 0.37 inch apart.

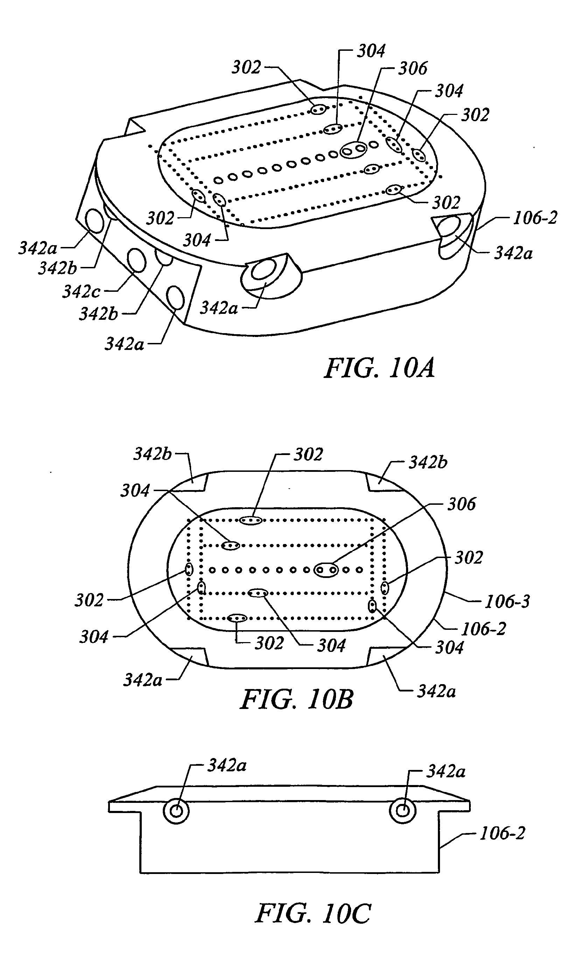

Figure 10A shows a proximity head 106-2 with an elongated ellipse shape in accordance with one embodiment of the present invention. The proximity head 106-2 includes the source inlets 302, source outlets 304, and source inlets 306. In this embodiment, the source inlets 302 are capable of applying IPA toward a wafer surface region, the source inlets 306 are capable of applying DIW toward the wafer surface region, and the source outlets 304 are capable of applying vacuum to a region in close proximity of a surface of the wafer 108. By the application of the vacuum, the IPA, DIW, and any other type of fluids that may reside on a wafer surface may be removed.

The proximity head 106-2 also includes ports 342a, 342b, and 342c that, in one embodiment, correspond to the source inlet 302, source outlet 304, and source inlet 306 respectively. By inputting or removing fluid through the ports 342a, 342b, and 342c, fluids may be inputted or outputted through the source inlet 302, the source outlet 304, and the source inlet 306. Although the ports 342a, 342b, and 342c correspond with the source inlet 302, the source outlet 304, and the source inlet 306 in this exemplary embodiment, it should be appreciated that the ports 342a, 342b, and 342c may supply or remove fluid from any suitable source inlet or source outlet depending on the configuration desired. Because of the configuration of the source inlets 302 and 306 with the source outlets 304, the meniscus 116 may be formed between the proximity head 106-2 and the wafer 108. The shape of the meniscus 116 may vary depending on the configuration and dimensions of the proximity head 106-2.

Figure 10B shows a top view of the proximity head 106-2 with an elongated ellipse shape in accordance with one embodiment of the present invention. In Figure 10B, the pattern of the source outlets 304 and the source inlets 302 and 306 is indicated. Therefore, in one embodiment, the proximity head 106-2 includes the source inlets 302 located outside of the source outlets 304 which are in turn located outside of the source inlets 306. Therefore, the source inlets 302 substantially surround the source outlets 304 which in turn substantially surround the source inlets 306 to enable the IPA-vacuum-DIW orientation. In one embodiment, the source inlets 306 are located down the middle of the long axis of the of the proximity head 106-2. In such an embodiment, the source inlets 302 and 306 input IPA and DIW respectively to a region of the wafer 108 that is being dried and/or cleaned. The source outlets 304 in this embodiment exert vacuum in close proximity of the region of the wafer 108 being dried thereby outputting the IPA and the DIW from the source inlets 302 and 306 as well as other fluids from the region of the wafer 108 that is being dried. Therefore, in one embodiment, a drying/cleaning action as discussed in reference to Figure 6 may occur to clean/dry the wafer 108 in an extremely effective manner.

Figure 10C shows a side view of the proximity head 106-2 with an elongated ellipse shape in accordance with one embodiment of the present invention. It should be appreciated that the proximity head 106-2 is exemplary in nature and may be any suitable dimension as long as the source inlets 302 and 306 as well as the source outlet 304 are configured in a manner to enable cleaning and/or drying of the wafer 108 in the manner described herein.

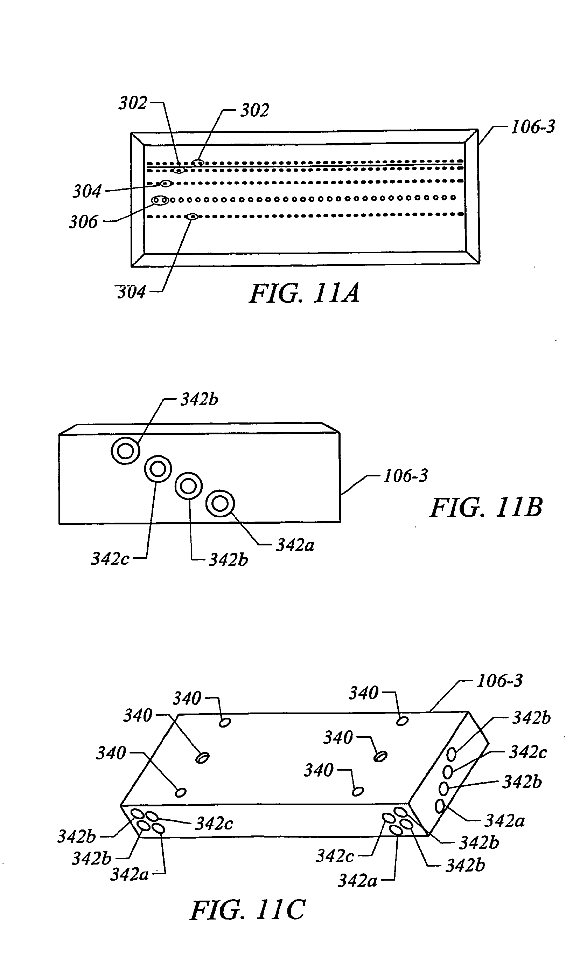

Figure 11A shows a top view of a proximity head 106-3 with a rectangular shape in accordance with one embodiment of the present invention. In this embodiment, as shown in Figure 11A, the proximity head 106-3 includes two rows of the source inlets 302 at the top of the figure, the source outlets 304 in a row below the source inlets 302, a row of source inlets 306 below the source outlets 304, and a row of the source outlets 304 below the source inlets 306. In one embodiment, IPA and DIW may be inputted to the region of the wafer 108 that is being dried through the source inlets 302 and 306 respectively. The source outlets 304 may be utilized to pull away fluids from the surface of the wafer 108 such as the IPA and the DIW in addition to other fluids on the surface of the wafer 108.

Figure 11B shows a side view of the proximity head 106-3 with a rectangular shape in accordance with one embodiment of the present invention. The proximity head 106-3 includes ports 342a, 342b, and 342c which, in one embodiment, may be utilized to input and/or output fluids through the source inlets 302 and 306 as well as the source outlets 304. It should be appreciated that any suitable number of ports 342a, 342b, and 342c may be utilized in any of the proximity heads described herein depending on the configuration and the source inlets and outlets desired.

Figure 11C illustrates a bottom portion of the proximity head 106-3 in a rectangular shape in accordance with one embodiment of the present invention. The proximity head 106-3 includes ports 342a, 342b, and 342c on a back portion while connecting holes 340 on the bottom portion may be utilized to attach the proximity head 106-3 to the top arm 104a as discussed above in reference to Figures 2A through 2D.

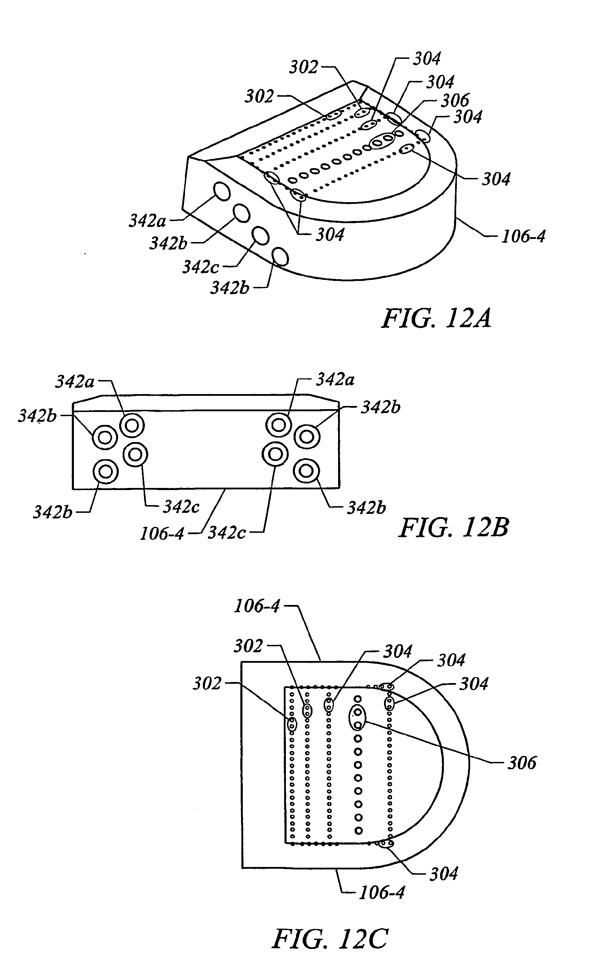

Figure 12A shows a proximity head 106-4 with a partial rectangular and partial circular shape in accordance with one embodiment of the present invention. In this embodiment, the proximity head 106-4 includes one row of source inlets 306 that is adjacent on both sides to rows of source outlets 304. One of the rows of source outlets 304 is adjacent to two rows of source inlets 302. Perpendicular to and at the ends of the rows described above are rows of source outlets 304.

Figure 12B shows a rear view of the proximity head 106-4 with a partial rectangular and partial circular shape in accordance with one embodiment of the present invention. In one embodiment, the proximity head 106-4 includes ports 342a, 342b, and 342c on a back side as shown by the rear view where the back side is the square end of the proximity head 106-4. The ports 342a, 342b, and 342c may be utilized to input and/or output fluids through the source inlets 302 and 306 and the source outlets 304. In one embodiment, the ports 342a, 342b, and 342c correspond to the source inlets 302, the source outlets 304, and the source inlets 306 respectively.

Figure 12C shows a top view of the proximity head 106-4 with a partial rectangular and partial circular shape in accordance with one embodiment of the present invention. As shown this view, the proximity head 106-4 includes a configuration of source inlets 302 and 306, and source outlets 304 which enable the usage of the IPA-vacuum-DIW orientation.

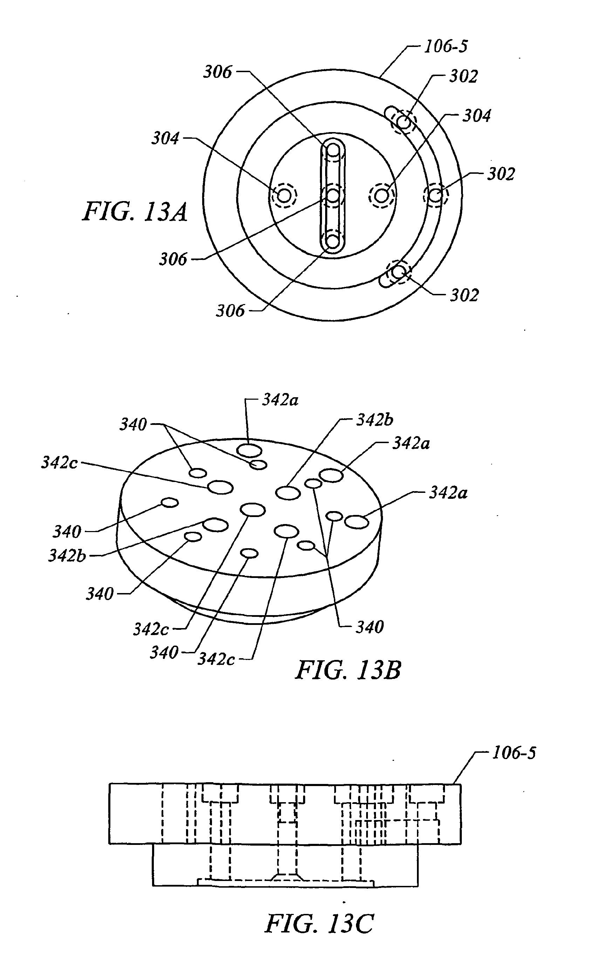

Figure 13A illustrates a top view of a proximity head 106-5 with a circular shape similar to the proximity head 106-1 shown in Figure 9A in accordance with one embodiment of the present invention. In this embodiment, the pattern of source inlets and source outlets is the same as the proximity head 106-1, but as shown in Figure 13B, the proximity head 106-5 includes connecting holes 340 where the proximity head 106-5 can be connected with an apparatus which can move the proximity head close to the wafer.

Figure 13B shows the proximity head 106-5 from a bottom view in accordance with one embodiment of the present invention. From the bottom view, the proximity head 106-5 has the connecting holes 340 in various locations on a bottom end. The bottom end may be connected to either the upper arm 106a or the bottom arm 106b if the proximity head 106-5 is utilized in the system 100 as shown above in reference to Figure 2A through 2D. It should be appreciated that the proximity head 106-5 may have any suitable number or type of connecting holes as long as the proximity head 106-5 may be secured to any suitable apparatus that can move the proximity head 106-5 as discussed above in reference to Figures 2A through 2D.

Figure 13C illustrates the proximity head 106-5 from a side view in accordance with one embodiment of the present invention. The proximity head 106-5 has a side that is a larger circumference than the side that moves into close proximity with the wafer 108. It should be appreciated although the circumference of the proximity head 106-5 (as well as the other embodiments of the proximity head 106 that is described herein) may be any suitable size and may be varied depending on how much surface of the wafer 108 is desired to be processed at any given time.

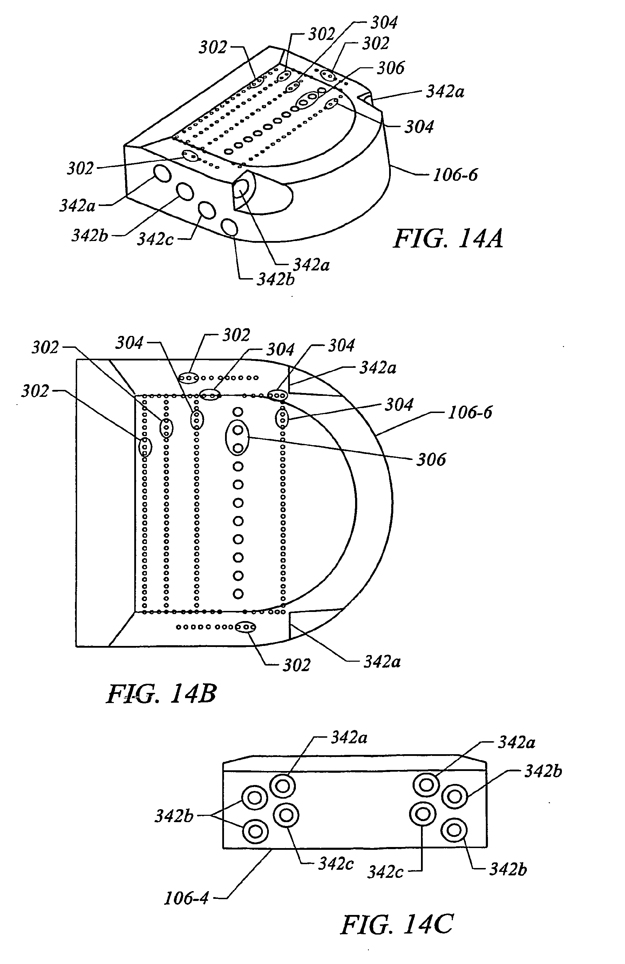

Figure 14A shows a proximity head 106-6 where one end is squared off while the other end is rounded in accordance with one embodiment of the present invention. In this embodiment, the proximity head 106-6 has a pattern of the source inlets 302 and 306 as well as the source outlets 304 similar to the pattern as shown in the proximity head 106-4 described in reference to Figure 12A except there are additional rows of source inlets 302 as can be seen from the top view of Figure 14B.

Figure 14B illustrates a top view of the proximity head 106-6 where one end is squared off while the other end is rounded in accordance with one embodiment of the present invention. In one embodiment, the proximity head 106-6 includes a dual tiered surface with the configuration of source inlets 302 and 306 and source outlets 304 that enables the ability to apply the IPA-vacuum-DIW orientation during wafer processing.

Figure 14C shows a side view of a square end of the proximity head 106-6 in accordance with one embodiment of the present invention. In this embodiment, the proximity head 106-6 includes the ports 342a, 342b, and 342c which enables input and output of fluid both to and from the source inlets 302 and 306 as well as the source outlets 304.

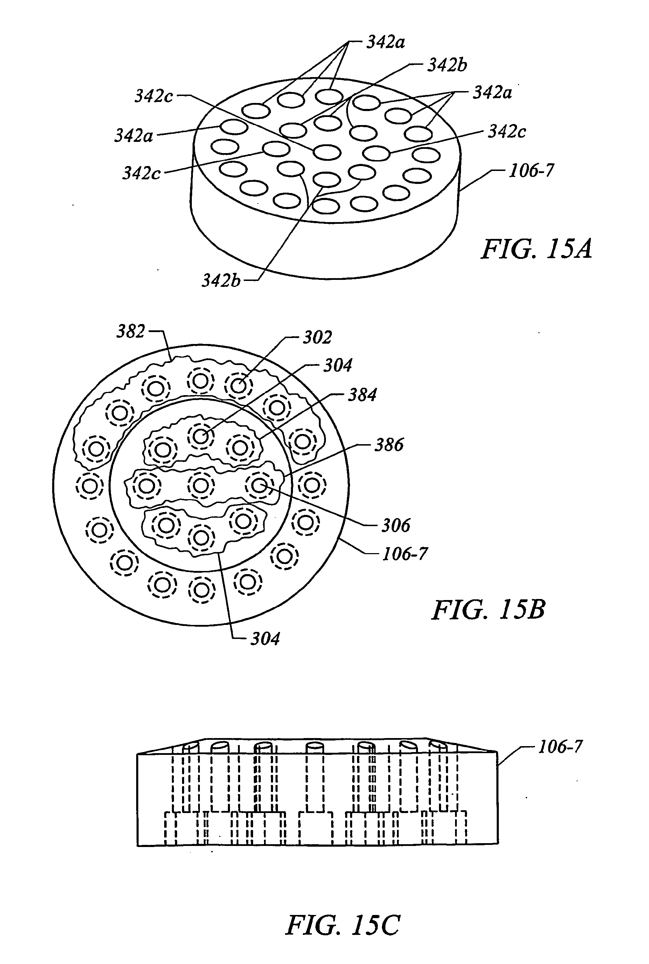

Figure 15A shows a bottom view of a 25 holes proximity head 106-7 in accordance with one embodiment of the present invention. In this embodiment, the proximity head 106-7 includes 25 openings any of which may be utilized as ports 342a, 342b, and 342c depending on the configuration desired. In one embodiment, seven openings are the ports 342a, six openings are the source outlets 342b, and three openings are ports 342c. In this embodiment, the other nine openings are left unused. It should be appreciated that the other holes may be used as ports 342a, 342b, and/or 342c depending on the configuration and type of function desired of the proximity head 106-7.

Figure 15B shows a top view of the 25 holes proximity head 106-7 in accordance with one embodiment of the present invention. The side of the proximity head 106-7 shown by Figure 15B is the side that comes into close proximity with the wafer 108 to conduct drying and/or cleaning operations on the wafer 108. The proximity head 106-7 includes an IPA input region 382, a vacuum outlet regions 384, and a DIW input region 386 in a center portion of the proximity head 106-7. In one embodiment, the IPA input region 382 includes a set of the source inlets 302, the vacuum outlet regions 384 each include a set of the source outlets 304, and the DIW input region 386 includes a set of the source inlets 306.

Therefore, in one embodiment when the proximity head 106-7 is in operation, a plurality of the source inlet 302 inputs IPA into the IPA input region, a plurality of the source outlet 304 generates a negative pressure (e.g., vacuum) in the vacuum outlet regions 384, and a plurality of the source inlet 306 inputs DIW into the DIW input region 386. In this way, the IPA-vacuum-DIW orientation may be utilized to intelligently dry a wafer.

Figure 15C shows a side view of the 25 holes proximity head 106-7 in accordance with one embodiment of the present invention. As shown in this view, a top surface of the proximity head 106-7 has a dual level surface. In one embodiment, the level with the plurality of the source inlet 302 is below the level with the plurality of the source outlet 304 and the plurality of the source inlet 306.

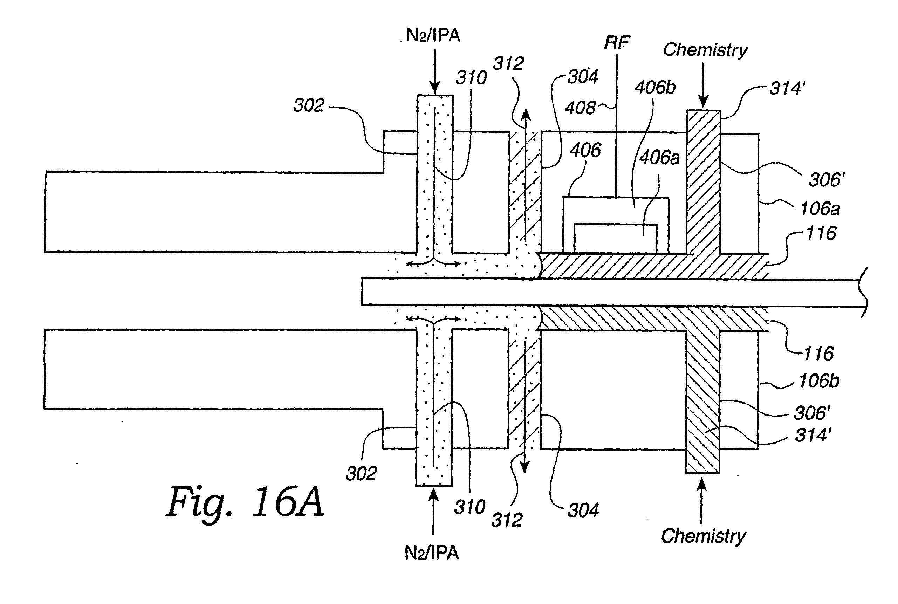

Figure 16A illustrates a side view of the proximity heads 106a and 106b for use in a wafer surface megasonic cleaning system in accordance with one embodiment of the present invention. In this embodiment, by usage of source inlets 302 and 306' to input N₂/IPA and cleaning chemistry respectively along with the source outlet 304 to provide a vacuum, the meniscus 116 may be generated. It should be appreciated that any suitable type of chemistry that can clean a wafer surface that is compatible with the material of the proximity heads 106a and 106b may be utilized. In addition, on the side of the source inlet 306' opposite that of the source inlet 302, there may be a source outlet 304 to remove cleaning chemistry and to keep the meniscus 116 intact. The source inlets 302 and 306' may be utilized for IPA inflow 310 and cleaning chemistry inflow 314' respectively while the source outlet 304 may be utilized to apply vacuum 312. It should be appreciated that any suitable configuration of source inlets 302, source outlets 304 and source inlets 306 may be utilized. For example, the proximity heads 106a and 106b may have a configuration of source inlets and source outlets like the configuration described above in reference to Figures 6A. In addition, in yet more embodiments, the proximity heads 106a and 106b may be of a configuration as shown below in reference to Figures 6B through 8B. In another embodiment, the proximity heads 106a and 106b may have different configurations. Any suitable surface coming into contact with the meniscus 116 may be cleaned by the movement of the meniscus 116 into and away from the surface.

The cleaning of the wafer 108 may be enhanced through the use of megasonics. In one embodiment, a transducer 406 may be defined within the proximity head(s) 106a. In a preferable embodiment, a transducer 406 may be defined within the proximity head 106a between the source outlet 304 and the source inlet 306'. Once the meniscus 116 has been formed, an RF supply 408 can supply a transducer 406 with energy. The transducer 406 converts the energy from the RF supply 408 into acoustic energy. It should be appreciated that the transducer may have any suitable configuration that would enable the conversion of RF to acoustic energy. In one embodiment, the transducer 406 is a piezoelectric crystal 406a bonded to a body 406b. In a preferable embodiment, the transducer is coated with a substance such as, for example, Teflon to protect the crystal 406a and the body 406b from the cleaning chemistry and contaminants that may exist on the surface of the wafer being cleaned. The acoustic energy may produce megasonic (600 kHz - 1.5 MHz) or ultrasonic (below 600 kHz) waves. In a preferable embodiment, the transducer 406 generates megasonic waves to create cavitations in the meniscus 116. The cavitations of the cleaning chemistry comprising the meniscus 116 enhance cleaning properties of the meniscus 116. Therefore, contaminants cleaned off of the wafer surface by the meniscus 116 is pulled off of the wafer through the source outlet 304. By using megasonics along with the controllable meniscus 116, the apparatus and methods described herein may enable usage of megasonic cleaning in a small volume space thereby enabling fast chemical exchange with improved mass transport during cleaning.

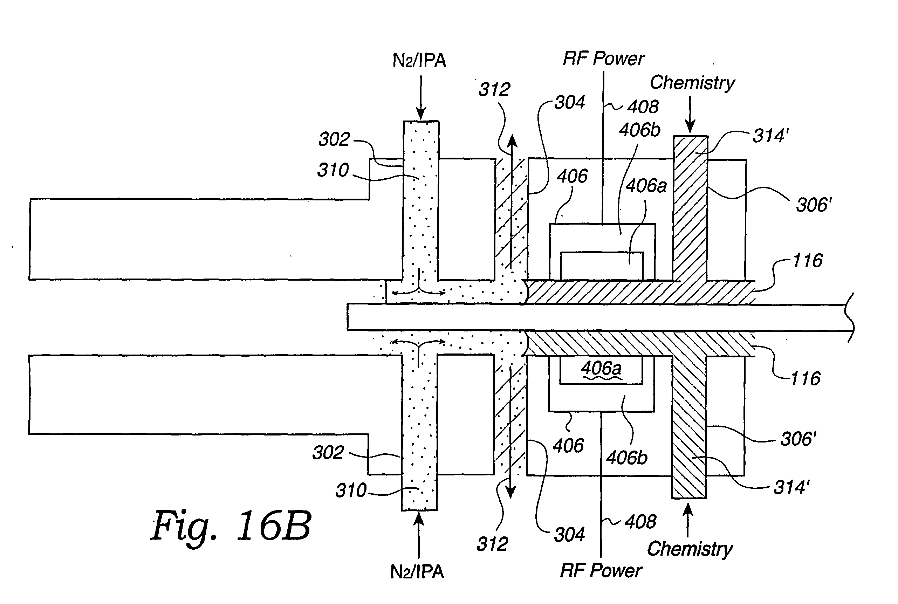

Figure 16B illustrates a side view of the proximity heads 106a and 106b for use in a dual wafer surface megasonic cleaning system in accordance with one embodiment of the present invention. In this embodiment, by usage of source inlets 302 and 306' to input N₂/IPA and cleaning chemistry respectively along with the source outlet 304 to provide a vacuum, the meniscuses 116 may be generated by the heads 106a and 106b on the top surface and the bottom surface of the wafer 108 respectively. In one embodiment, the proximity head 106b may have the same configuration as the proximity head 106a except the proximity head 106b is positioned to process the other side of the wafer 108. In addition, the megasonic transducer 406 may be defined within each of the heads 106a and 106b. The RF supply may provide RF energy for the piezoelectric crystal 406a to convert to acoustic energy. The acoustic energy may then be applied to the meniscuses 116 on both the top surface and the bottom surface of the wafer. Consequently, dual surface megasonic meniscus cleaning may be conducted.

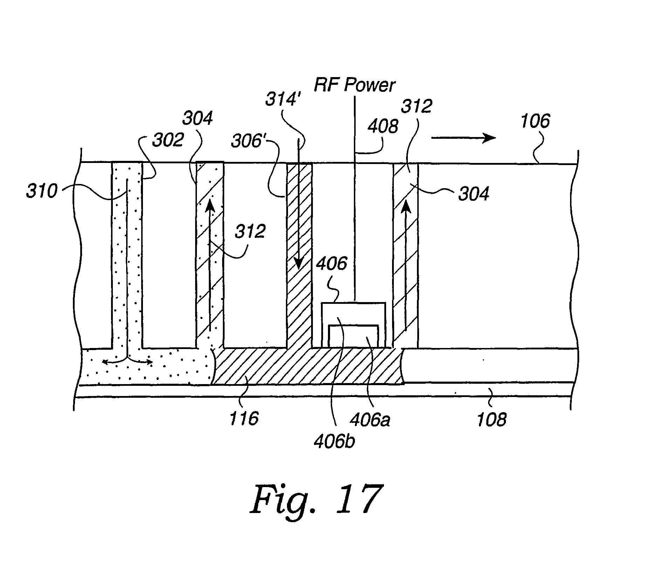

Figure 17 illustrates a side view of a proximity head 106 where a megasonic transducer 406 is located between a source outlet 304 and a source inlet 306' in accordance with one embodiment of the present invention. In one embodiment, the proximity head 106 has a IPA-vacuum-liquid-megasonic-vacuum configuration. In operation, the IPA/N₂ is inputted through the source inlet 302, the vacuum is applied through the source outlet 304, the liquid is applied through the source inlet 306', and megasonic acoustic waves are applied by the transducer 406 to the meniscus 116, and the vacuum on the leading edge side of the proximity head 106 is applied by the source outlet 304. Therefore, in this way, the meniscus 116 comprising the cleaning chemistry may be formed and the megasonic transducer 406 which is in direct contact with the meniscus 116 may apply ultrasonic or megasonic acoustic waves. As discussed above, the acoustic waves may generate cavitation in the meniscus 116 thereby enhancing the cleaning properties of the cleaning chemistry that is in contact with a surface of the wafer 108.

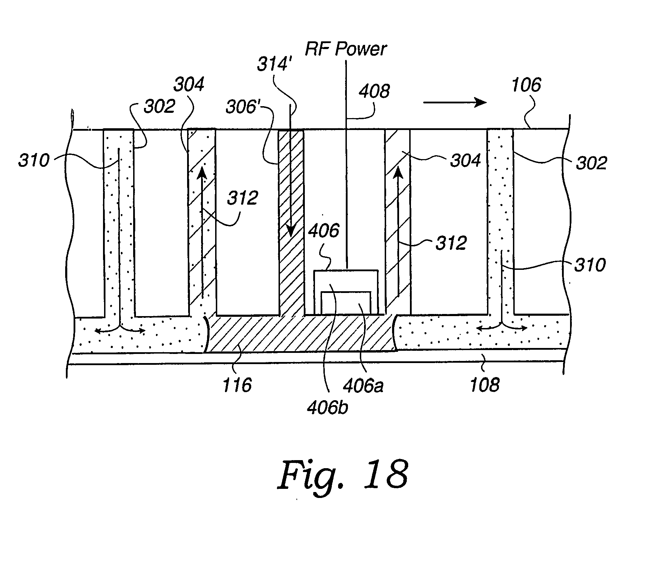

Figure 18 illustrates a side view of a proximity head 106 with the configuration as discussed in reference to Figure 7A with a megasonic transducer 406 is located between a source outlet 304 and a source inlet 306' on a leading edge side in accordance with one embodiment of the present invention. In this embodiment, the meniscus 116 may be confined by IPA vapor on both the leading edge and the trailing edge of the proximity head 106. The meniscus 116 is located on a leading edge side of the source inlet 306'.

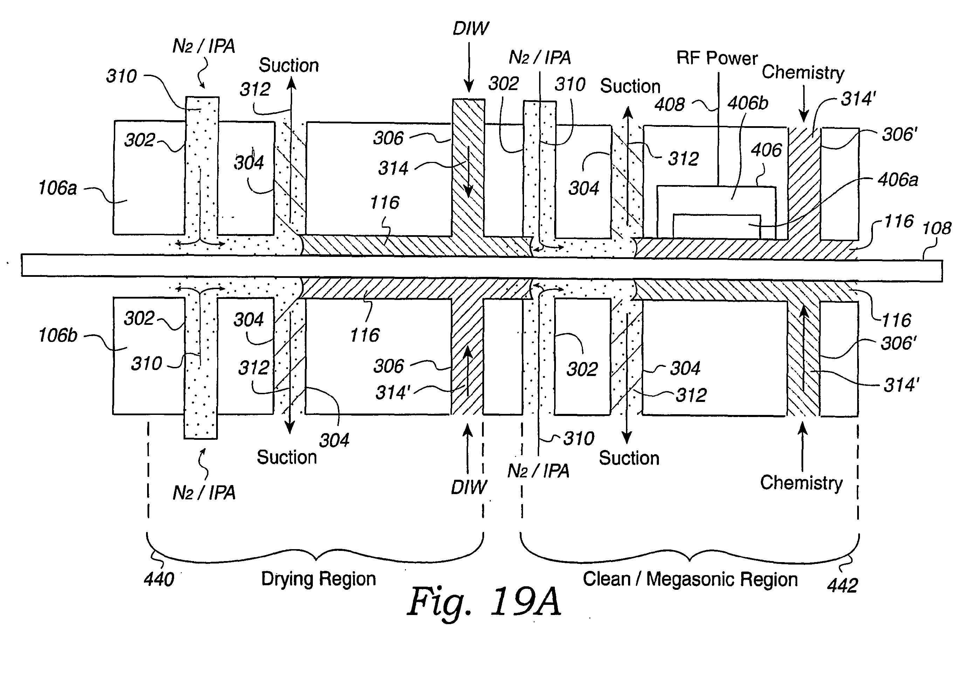

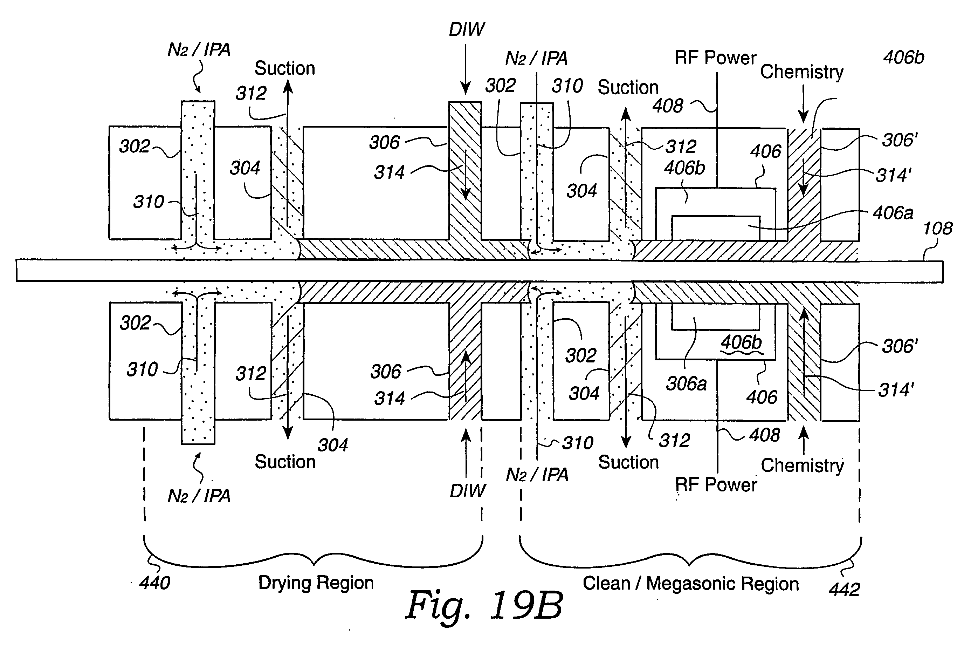

Figure 19A shows a side view of proximity heads 106a and 106b with a combination of a clean/megasonic region 442 and a drying region 440 in accordance with one embodiment of the present invention. In one embodiment, the clean/megasonic region 442 includes the source inlet 302, the source outlet 304, and the source inlet 306'. The megasonic transducer 406 is defined in the head 106a such a way that the transducer 406 may contact the meniscus 116 in the clean/megasonic region 442. In a preferable embodiment, the clean region 442 is located on a leading edge side of the proximity head 106 as compared with the location of the drying region 440. In one embodiment, the drying region 440 includes the source inlet 302, the source outlet 304, and the source inlet 306. In such an embodiment, the source inlet 306 inputs deionized water. In this way the wafer 108 may be cleaned in a highly efficient manner.

Figure 19B shows a side view of proximity heads 106a and 106b with dual megasonic transducers in the clean/megasonic region 442 in accordance with one embodiment of the present invention. In one embodiment, both the proximity heads 106a and 106b each include transducers that may turn RF into acoustic energy. In one embodiment, the proximity head 106b has the same configuration of the proximity head 106a except the proximity head 106b positioned to process the other side of the wafer 108. In one embodiment, the transducers 406 of both the heads 106a and 106b may be configured to output megasonic waves directly to the meniscus 116. In a preferable embodiment, the transducers 406 may be configured to output megasonic waves directly to the meniscuses 116 on both sides of the wafer 108. It should also be appreciated that the transducers may be located in any portion of the proximity heads 106a and 106b that may enable acoustic waves to be outputted directly to the meniscus 116 that is cleaning the wafer. In a preferable embodiment, the location of the transducers 406 may be in the location as described above in reference to Figure 19A.

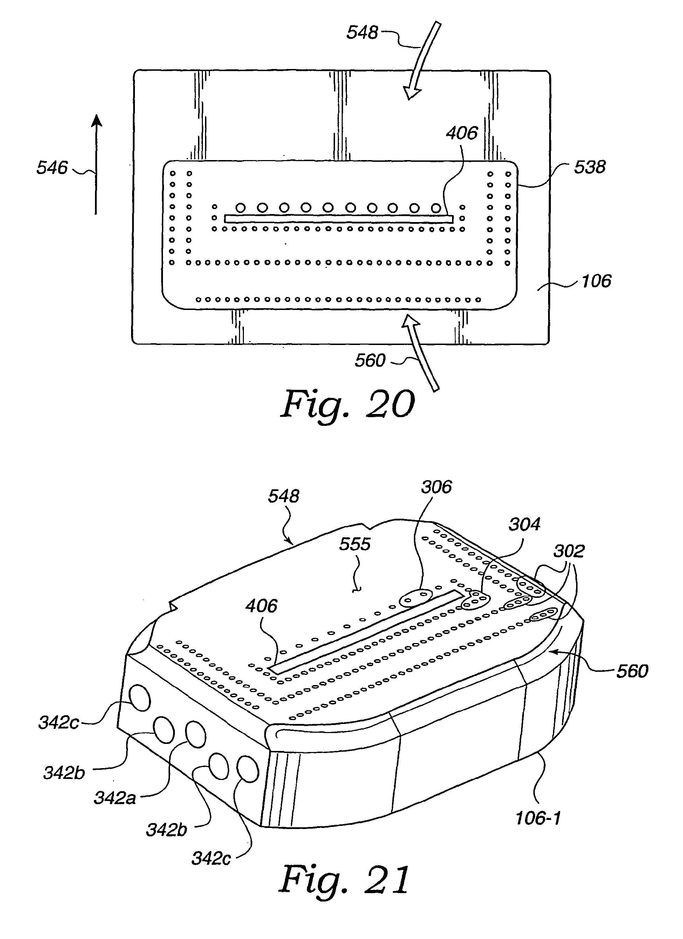

Figure 20 shows an exemplary process window 538 with the plurality of source inlets 302 and 306 as well as the plurality of source outlets 304 in accordance with one embodiment of the present invention. In one embodiment, the process window 538 in operation may be moved in direction 546 across a wafer during, for example, a wafer cleaning operation. The process window 538 is the location where the meniscus 116 may be formed. In such an embodiment, a proximity head 106 may encounter contaminated areas on a wafer surface on a leading edge region 548. The leading edge region 548 is an area of the proximity head 106 that, in a cleaning process, encounters contaminants first. Conversely a trailing edge region 560 is an area of the proximity head 106 that encounters the area being processed last. As the proximity head 106 and the process window 538 included therein move across the wafer in the direction 546, the dirty area (or a wet area in a drying operation) of the wafer surface enter the process window 538 through the leading edge region 548. Then after processing of the unclean region (or a wet region in a drying process) of the wafer surface by the meniscus that is generated and controllably maintained and managed by the process window 538, the unclean region is cleaned and the cleaned region of the wafer (or substrate) leaves the process window 538 through a trailing edge region 560 of the proximity head 106. In an alternative embodiment, a wet region is dried and the dried region of the wafer leaves the process window 538 through the trailing edge region 560 of the proximity head 106.

In one embodiment, the transducer 406 may be defined between the source inlets and the source outlets. Therefore, the transducer 406 may be defined within the process window 538 in a manner that enables the transducer 406 to directly apply acoustic waves to a meniscus formed by the process window 538. Therefore the cleaning chemistry that make up the meniscus 116 and the cavitations formed within the meniscus 116 may optimally clean the surface of the wafer.

It should be appreciated any of the different embodiments of the proximity head 106 described may be used as one or both of the proximity heads 106a and 106b described above in reference to Figures 2A through 5H. The proximity head may be any suitable configuration or size that may enable the fluid removal and/or cleaning process as described. In addition, exemplary proximity heads and their respective patterns of the source inlets 302 and 304 as well as the source outlets 306 may be seen in U.S. Patent Applications Nos. 10/261,839, 10/404,270, and 10/330, 897 which have been incorporated by reference. Therefore, any, some, or all of the proximity heads described herein may be utilized in any suitable wafer cleaning and drying system such as, for example, the system 100 or a variant thereof as described in reference to Figures 2A to 2D. In addition, the proximity head may also have any suitable numbers or shapes of source outlets 304 and source inlets 302 and 306. Moreover, the transducer 406 may be any suitable size, shape, and number as long the transducer 406 may apply acoustic waves to the meniscus 116. It should be appreciated that the side of the proximity heads shown from a top view is the side that comes into close proximity with the wafer to conduct wafer processing.

The proximity head described in Figure 21 is a manifold that enables usage of the IPA-vacuum-liquid orientation as described above. In addition, the proximity heads described herein may be utilized for either cleaning or drying operations depending on the fluid that is inputted and outputted from the source inlets 302 and 306, and the source outlets 304. In addition, the proximity heads described herein may have multiple inlet lines and multiple outlet lines with the ability to control the relative flow rates of liquid and/or vapor and/or gas through the outlets and inlets. It should be appreciated that every group of source inlets and source outlets can have independent control of the flows.

It should be appreciated that the size as well as the locations of the source inlets and outlets may be varied as long as the meniscus produced is stable. In one embodiment, the size of the openings to source inlets 302, source outlets 304, and source inlets 306 are between about 0.02 inch and about 0.25 inch in diameter. In a preferable embodiment, the size of the openings of the source inlets 306 and the source outlets 304 is about 0.06 inch, and the size of the openings of the source inlets 302 is about 0.03 inch.

In one embodiment the source inlets 302 and 306 in addition to the source outlets 304 are spaced about 0.03 inch and about 0.5 inch apart. In a preferable embodiment, the source inlets 306 are spaced 0.125 inch apart from each other and the source outlets 304 are spaced 0.125 inch apart and the source inlets 302 are spaced about 0.06 inch apart. In one embodiment, the source inlets 302, the source outlets 304 may be combined in the form of one or more slots or channels rather than multiple openings. By way of example, the source outlets 304 may be combined in the form of one or more channels that at least partially surrounds the area of the source outlets 306 for the portion of the meniscus. Similarly, the IPA outlets 302 can be combined into one or more channels that lie outside the area of the source inlets 304. The source outlets 306 can also be combined into one or more channels.

Additionally, the proximity heads may not necessarily be a "head" in configuration but may be any suitable configuration, shape, and/or size such as, for example, a manifold, a circular puck, a bar, a square, an oval puck, a tube, plate, etc., as long as the source inlets 302, and 306, and the source outlets 304 may be configured in a manner that would enable the generation of a controlled, stable, manageable fluid meniscus. A single proximity head can also include sufficient source inlets 302 and 306, and the source outlets 304 such that the single proximity head can also support multiple meniscuses. The multiple meniscuses can simultaneously perform separate functions (e.g., etch, rinse, and drying processes). In a preferable embodiment, the proximity head may be a type of manifold as described in reference to the Figures or other suitable configurations. The size of the proximity heads may be varied to any suitable size depending on the application desired. In one embodiment, the length (from a top view showing the process window) of the proximity heads may be between 1.0 inch to about 18.0 inches and the width (from a top view showing the process window) may be between about 0.5 inch to about 6.0 inches. Also when the proximity head may be optimized to process any suitable size of wafers such as, for example, 200mm wafers, 300, wafers, etc. The process windows of the proximity heads may be arranged in any suitable manner as long as such a configuration may generate a controlled stable and manageable fluid meniscus.

Figure 21 shows a top view of a proximity head 106-1 with a substantially rectangular shape in accordance with one embodiment of the present invention. In this embodiment, the proximity head 106-1 includes three of the source inlets 302 which, in one embodiment, applies IPA to a surface of the wafer 108.

In this embodiment, the source inlets 302 are capable of applying IPA toward a wafer surface region, the source inlets 306 are capable of applying cleaning chemistry toward the wafer surface region, and the source outlets 304 are capable of applying vacuum to a region in close proximity of a surface of the wafer 108. By the application of the vacuum, the IPA, cleaning chemistry, and any other type of fluids that may reside on a wafer surface may be removed.

The proximity head 106-1 also includes ports 342a, 342b, and 342c that, in one embodiment, correspond to the source inlet 302, source outlet 304, and source inlet 306 respectively. By inputting or removing fluid through the ports 342a, 342b, and 342c, fluids may be inputted or outputted through the source inlet 302, the source outlet 304, and the source inlet 306. Although the ports 342a, 342b, and 342c correspond with the source inlet 302, the source outlet 304, and the source inlet 306 in this exemplary embodiment, it should be appreciated that the ports 342a, 342b, and 342c may supply or remove fluid from any suitable source inlet or source outlet depending on the configuration desired. Because of the configuration of the source inlets 302 and 306 with the source outlets 304, the meniscus 116 may be formed between the proximity head 106-1 and the wafer 108. The shape of the meniscus 116 may vary depending on the configuration and dimensions of the proximity head 106-1.

It should be appreciated that the ports 342a, 342b, and 342c for any of the proximity heads described herein may be any suitable orientation and dimension as long as a stable meniscus can be generated and maintained by the source inlets 302, source outlets 304, and source inlets 306. The embodiments of the ports 342a, 342b, and 342c described herein may be applicable to any of the proximity heads described herein. In one embodiment, the port size of the ports 342a, 342b, and 342c may be between about 0.03 inch and about 0.25 inch in diameter. In a preferable embodiment, the port size is about 0.06 inch to 0.18 inch in diameter. In one embodiment, the distance between the ports is between about 0.125 inch and about 1 inch apart. In a preferable embodiment, the distance between the ports is between about 0.25 inch and about 0.37 inch apart.

In one embodiment, the transducer 406 is located in between the source inlets 306 and the source outlets 304. It should be appreciated that the transducer 406 may be located in any suitable region of the head 106-1 as long as the transducer 406 may apply acoustic waves to the meniscus 116. Therefore, the transducer 406 may apply acoustic waves such as, for example, ultrasonic waves and/or megasonic waves to the meniscus 116 as described above. Consequently, by use of cleaning chemicals and megasonics, the cleaning of wafer surfaces may be intelligently optimized and enhanced.

While this invention has been described in terms of several preferred embodiments, it will be appreciated that those skilled in the art upon reading the preceding specifications and studying the drawings will realize various alterations, additions, permutations and equivalents thereof. It is therefore intended that the present invention includes all such alterations, additions, permutations, and equivalents as set forth in the appended claims.

## Claims

1. A substrate preparation system (100), comprising:
a head (106a, 106b) having a head surface, the head surface configured to be proximate to a surface (108a, 108b) of the substrate (108) when in operation;
a first conduit (302) adapted to deliver a first fluid to the surface (108a, 108b) of the substrate (108) through the head (106a, 106b);
a second conduit (306) adapted to deliver a second fluid to the surface (108a, 108b) of the substrate (108) through the head (106a, 106b), the second fluid being different than the first fluid; and
a third conduit (304) adapted to remove each of the first fluid and the second fluid from the surface (108a, 108b) of the substrate (108),
**characterised in that** the first conduit (302), the second conduit (306) and the third conduit (304) are configured to act simultaneously when in operation.

2. A substrate preparation system as recited in claim 1, wherein the substrate (108) moves so that the head (106a, 106b) traverses the surface (108a, 108b) of the substrate (108).

3. A substrate preparation system as recited in claim 1, wherein the head (106a, 106b) moves to traverses the surface (108a, 108b) of the substrate (108).

4. A substrate preparation system as recited in claim 1, wherein the head (106a, 106b) extends in size up to a diameter of the substrate (108).

5. A substrate preparation system as recited in claim 1, wherein the head (106a, 106b) has a length that is larger than a diameter of the substrate (108).

6. A substrate preparation system as recited in claim 1, wherein a second head is positioned on an opposite side of the head and made to be proximate to an undersurface of the substrate (108) when in operation.

7. A substrate preparation system as recited in claim 1, wherein the first fluid is one of deionized water (DIW) and a cleaning fluid.

8. A substrate preparation system as recited in claim 1, wherein the second fluid is one of isopropyl alcohol (IPA) vapor, nitrogen, organic compounds, hexanol, ethyl glycol, and compounds miscible with water.

9. A method for processing substrate, comprising:
applying a first fluid onto a surface (108a, 108b) of a substrate (108);
applying a second fluid onto the surface (108a, 108b) of the substrate (108), the second fluid being applied in close proximity to the application of the first fluid; and
removing the first fluid and the second fluid from the surface (108a, 108b) of the substrate (108), the removing being processed just as first fluid and the second fluid are applied to the surface (108a, 108b) of the substrate (108);
wherein the applying and the removing forming a controlled meniscus (116).

10. A method for processing substrate as recited in claim 9, wherein the first fluid is one of DIW and a cleaning fluid.

11. A method for processing substrate as recited in claim 9, wherein the first fluid is one of isopropyl alcohol (IPA) vapor, nitrogen, organic compounds, hexanol, ethyl glycol, and compounds miscible with water.

12. A method for processing substrate as recited in claim 9, wherein the removing the first fluid and the second fluid includes applying a vacuum in close proximity to the surface (108a, 108b) of the substrate (108).

13. A method for processing substrate as recited in claim 12, wherein applying the vacuum includes adjusting a magnitude of the vacuum to form the stable meniscus.

14. A substrate preparation apparatus (100) to be used in substrate processing operations, comprising:
a proximity head (106a, 106b) being moveable toward a substrate surface (108a, 108b), the proximity head (106a, 106b) including;
at least one of a first source inlet (302), the first source inlet (302) adapted to apply a first fluid towards the substrate surface (108a, 108b) when the proximity head (106a, 106b) is in a position that is close to the substrate surface (108a, 108b);
at least one of a second source inlet (306), the second source inlet (306) adapted to apply a second fluid towards the substrate surface (108a, 108b) when the proximity head (106a, 106b) is in the position that is close to the substrate surface (108a, 108b); and
at least one of a source outlet (304), the source outlet (304) adapted to apply a vacuum pressure to remove the first fluid and the second fluid from the substrate surface (108a, 108b) when the proximity head (106a. 106b) is in the position that is close to the substrate surface (108a, 108b).

15. A substrate preparation apparatus as recited in claim 14, wherein the first inlet (302) is configured to introduce an isopropyl alcohol (IPA) vapor toward the substrate.

16. A substrate preparation apparatus as recited in claim 14, wherein the second inlet (306) is configured to introduce deionized water (DIW) toward the substrate.

17. A substrate preparation apparatus as recited in claim 14, wherein the proximity head (106a, 106b) is configured to produce a meniscus on the substrate when the proximity head (106a, 106b) is moved in close proximity to the substrate (108).

18. A substrate preparation apparatus as recited in claim 14, further comprising:
a proximity head carrier assembly configured to move the proximity head (108a, 106b) in a linear movement along a radius of the substrate.

19. A method for processing a substrate as recited in claim 9, wherein generating the fluid meniscus includes:
applying a first fluid onto a first region of the surface (108a, 108b) of the substrate;
applying a second fluid onto a second region of the surface (108a, 108b) of the substrate; and
removing the first fluid and the second fluid from the surface (108a, 108b) of the substrate, the removing occurring from a third region that substantially surrounds the first region;
wherein the second region substantially surrounds at least a portion of the third region, and the applying and the removing forms the fluid meniscus.

20. A method for processing substrate as recited in claim 19, wherein the first fluid is a cleaning fluid.

21. A method for processing substrate as recited in claim 19, wherein the second fluid is one of isopropyl alcohol (IPA) vapor, organic compounds, hexanol, ethyl glycol, and compounds miscible with water.

22. A method for processing substrate as recited in claim 19, wherein the removing the first fluid and the second fluid includes applying a vacuum in close proximity to the surface (108a, 108b) of the substrate.

23. A head (106a, 106b) used in a substrate preparation apparatus (100), comprising:
at least one of a first source inlet (302) adapted to deliver a first fluid to the surface (108a, 108b) of the substrate (108) through the head (106a, 106b);
at least one of a second source inlet (306) adapted to deliver a second fluid to the surface (108a, 108b) of the substrate (108) through the head (106a, 106b), the second fluid being different than the first fluid; and
at least one of a source outlet (304) adapted to remove each of the first fluid and the second fluid from the surface (108a, 108b) of the substrate (108), at least a portion of the at least one of the source outlet being located in between the at least one of the first source inlet (302) and the at least one of the second source inlet (306), and the at least one of the first source inlet (302), the at least one of the second source inlet (306), and the at least one of the source outlet (304) being configured to act simultaneously when in operation; and
a transducer (406) being capable of applying acoustic energy to the first fluid;
wherein the at least one of the second source inlet (306) surrounds at least a trailing edge side of the at least one of the source outlet (304).

24. A head used in a substrate preparation apparatus as recited in claim 23, wherein the first fluid is a cleaning chemistry.

25. A head used in a substrate preparation apparatus as recited in claim 23, wherein the transducer (406) includes a body and a piezoelectric crystal defined in the body.

26. A head used in a substrate preparation apparatus as recited in claim 25, wherein the transducer is attached to an RF supply and the piezoelectric crystal within the transducer is capable of receiving RF and generating the acoustic energy.

27. A head used in a substrate preparation apparatus as recited in claim 23, wherein the acoustic energy are at least one of an ultrasonic waves and megasonic waves.

## Patentansprüche

1. Vorbereitungssystem (100) für Substrate, umfassend:
einen Kopf (106a, 106b) mit einer Kopffläche, wobei die Kopffläche so ausgebildet ist, dass sie sich im Betrieb in der Nähe einer Oberfläche (108a, 108b) des Substrats (108) befindet;
eine erste Leitung (302), die ausgebildet ist, ein erstes Fluid durch den Kopf (106a, 106b) zu der Oberfläche (108a, 108b) des Substrats (108) zuzuführen; eine zweite Leitung (306), die ausgebildet ist, ein zweites Fluid durch den Kopf (106a, 106b) zu der Oberfläche (108a, 108b) des Substrats (108) zuzuführen, wobei sich das zweite Fluid von dem ersten Fluid unterscheidet, und
eine dritte Leitung (304), die ausgebildet ist, das erste Fluid und das zweite Fluid von der Oberfläche (108a, 108b) des Substrats (108) zu entfernen,
**dadurch gekennzeichnet, dass** die erste Leitung (302), die zweite Leitung (306) und die dritte Leitung (304) so ausgebildet sind, dass sie im Betrieb gleichzeitig arbeiten.

2. Vorbereitungssystem für Substrate nach Anspruch 1, bei dem sich das Substrat (108) bewegt, so dass der Kopf (106a, 106b) die Oberfläche (108a, 108b) des Substrats (108) überquert.

3. Vorbereitungssystem für Substrate nach Anspruch 1, bei dem sich der Kopf (106a, 106b) bewegt, um die Oberfläche (108a, 108b) des Substrats (108) zu überqueren.

4. Vorbereitungssystem für Substrate nach Anspruch 1, bei dem sich der Kopf (106a, 106b) größenmäßig bis zu dem Durchmesser des Substrats (108) erstreckt.

5. Vorbereitungssystem für Substrate nach Anspruch 1, bei dem der Kopf (106a, 106b) eine Länge hat, die größer als der Durchmesser des Substrats (108) ist.

6. Vorbereitungssystem für Substrate nach Anspruch 1, bei dem ein zweiter Kopf auf einer dem Kopf gegenüberliegenden Seite angeordnet und so ausgebildet ist, dass er im Betrieb in der Nähe der Unterseite des Substrats (108) angeordnet ist.

7. Vorbereitungssystem für Substrate nach Anspruch 1, bei dem das erste Fluid deionisiertes Wasser (DIW) oder ein Reinigungsfluid ist.

8. Vorbereitungssystem für Substrate nach Anspruch 1, bei dem das zweite Fluid ein Mitglied aus der Gruppe lsopropylalkoholdampf (IPA-Dampf), Stickstoff, organische Zusammensetzungen, Hexanol, Ethylglykol oder mit Wasser mischbare Zusammensetzungen ist.

9. Verfahren zur Bearbeitung eines Substrats, umfassend:
Aufbringen eines ersten Fluids auf eine Oberfläche (108a, 108b) eines Substrats(108);
Aufbringen eines zweiten Fluids auf die Oberfläche (108a, 108b) des
Substrats(1 08), wobei das zweite Fluid in unmittelbarer Nähe zu dem ersten Fluid aufgebracht wird, und
Entfernen des ersten Fluids und des zweiten Fluids von der Oberfläche (108a, 108b) des Substrats (108), wobei das Entfernen während des Aufbringens des ersten Fluids und des zweiten Fluids auf die Oberfläche (108a, 108b) des Substrats (108) durchgeführt wird,
wobei das Aufbringen und das Entfernen einen gesteuerten Meniskus (116) bilden.

10. Verfahren zur Bearbeitung eines Substrats nach Anspruch 9, bei dem das erste Fluid DIW oder ein Reinigungsfluid ist.

11. Verfahren zur Bearbeitung eines Substrats nach Anspruch 9, bei dem das erste Fluid ein Mitglied aus der Gruppe lsopropylalkoholdampf (IPA-Dampf), Stickstoff, organische Zusammensetzungen, Hexanol, Ethylglykol oder mit Wasser mischbare Zusammensetzungen ist.

12. Verfahren zur Bearbeitung eines Substrats nach Anspruch 9, bei dem das Entfernen des ersten Fluids und des zweiten Fluids das Anlegen eines Vakuums in unmittelbarer Nähe zu der Oberfläche (108a, 108b) des Substrats (108) umfasst.

13. Verfahren zur Bearbeitung eines Substrats nach Anspruch 12, bei dem das Anlegen des Vakuums das Einstellen einer Stärke des Vakuums zur Bildung des stabilen Meniskus umfasst.

14. Vorbereitungsvorrichtung (100) für Substrate zur Verwendung in Substratbearbeitungsvorgängen, umfassend:
einen Nahkopf (1 06a, 106b), der in Richtung auf eine Substratoberfläche (1 08a, 108b) bewegbar ist, wobei der Nahkopf (106a, 106b) umfasst:
mindestens eine erste Zuführung (302), wobei die erste Zuführung (302) zum Leiten eines ersten Fluids in Richtung auf die Substratoberfläche (108a, 108b) ausgebildet ist, wenn der Nahkopf (106a, 106b) in einer Position in der Nähe der Substratoberfläche (108a, 108b) ist;
mindestens eine zweite Zuführung (306), wobei die zweite Zuführung (306) zum Leiten eines zweiten Fluids in Richtung auf die Substratoberfläche (108a, 108b) ausgebildet ist, wenn der Nahkopf (106a, 106b) in einer Position in der Nähe der Substratoberfläche (108a, 108b) ist, und
mindestens einen Abfluss (304), wobei der Abfluss (304) zum Anlegen eines Vakuums ausgebildet ist, um das erste Fluid und das zweite Fluid von der Substratoberfläche (108a, 108b) zu entfernen, wenn der Nahkopf (106a, 106b) in einer Position in der Nähe der Substratoberfläche (108a, 108b) ist.

15. Vorbereitungsvorrichtung für Substrate nach Anspruch 14, bei der der erste Einlass (302) zum Zuführen eines Isopropylalkoholdampfes (IPA-Dampf) in Richtung auf das Substrat ausgebildet ist.

16. Vorbereitungsvorrichtung für Substrate nach Anspruch 14, bei der der zweite Einlass (306) zum Zuführen von deionisiertem Wasser (DIW) in Richtung auf das Substrat ausgebildet ist.

17. Vorbereitungsvorrichtung für Substrate nach Anspruch 14, bei der der Nahkopf (106a, 106b) zum Bilden eines Meniskus auf dem Substrat ausgebildet ist, wenn der Nahkopf (1 06a, 106b) in unmittelbare Nähe zu dem Substrat (108) bewegt ist.

18. Vorbereitungsvorrichtung für Substrate nach Anspruch 14, weiter umfassend:
eine Nahkopfträgeranordnung, die so ausgebildet ist, dass sie den Nahkopf (106a, 106b) in einer linearen Bewegung entlang eines Radius des Substrats bewegt.

19. Verfahren zur Bearbeitung eines Substrats nach Anspruch 9, bei dem das Erzeugen des Fluidmeniskus umfasst:
Aufbringen eines ersten Fluids auf einen ersten Bereich der Oberfläche (108a, 108b) des Substrats;
Aufbringen eines zweiten Fluids auf einen zweiten Bereich der Oberfläche (108a, 108b) des Substrats, und
Entfernen des ersten und des zweiten Fluids von der Oberfläche (108a, 108b) des Substrats, wobei das Entfernen von einem dritten Bereich aus stattfindet, der den ersten Bereich im Wesentlichen umgibt;
wobei der zweite Bereich im Wesentlichen mindestens einen Teil des dritten Bereichs umgibt und das Entfernen den Fluidmeniskus bildet.

20. Verfahren zur Bearbeitung eines Substrats nach Anspruch 19, bei dem das erste Fluid ein Reinigungsfluid ist.

21. Verfahren zur Bearbeitung eines Substrats nach Anspruch 19, bei dem das zweite Fluid Mitglied aus der Gruppe Isopropylalkoholdampf (IPA-Dampf), organische Zusammensetzungen, Hexanol, Ethylglykol oder mit Wasser mischbare Zusammensetzungen ist.

22. Verfahren zur Bearbeitung eines Substrats nach Anspruch 19, bei dem das Entfernen des ersten Fluids und des zweiten Fluids das Anlegen eines Vakuums in unmittelbarer Nähe zu der Oberfläche (108a, 108b) des Substrats umfasst.

23. Kopf (106a, 106b) zur Verwendung in einer Substratvorbereitungsvorrichtung (100), umfassend:
mindestens eine erste Zuführung (302), die zum Leiten eines ersten Fluids auf die Oberfläche (108a, 108b) des Substrats (108) durch den Kopf (106a, 106b) ausgebildet ist;
mindestens eine zweite Zuführung (306), die zum Leiten eines zweiten Fluids auf die Oberfläche (108a, 108b) des Substrats (108) durch den Kopf (106a, 106b) ausgebildet ist, und
mindestens einen Abfluss (304), der zum Entfernen des ersten und des zweiten Fluids von der Oberfläche (108a, 108b) des Substrats (108) ausgebildet ist,
wobei mindestens ein Teil des mindestens einen Auslasses zwischen der mindestens einen ersten Zuführung (302) und der mindestens einen zweiten Zuführung (306) angeordnet ist, und wobei die mindestens eine erste Zuführung (302), die mindestens eine zweite Zuführung (306) und der mindestens eine Auslass (304) so ausgebildet sind, dass sie im Betrieb gleichzeitig arbeiten; einen Wandler (406), der in der Lage ist, akustische Energie in das erste Fluid einzubringen;
wobei die mindestens eine zweite Zuführung (306) mindestens eine Seite am hinteren Ende des mindestens einen Auslasses (304) umgibt.

24. Kopf zur Verwendung in einer Substratvorbereitungsvorrichtung nach Anspruch 23, bei dem das erste Fluid eine Reinigungschemikalie ist.

25. Kopf zur Verwendung in einer Substratvorbereitungsvorrichtung nach Anspruch 23, bei dem der Wandler (406) einen Körper und einen in dem Körper ausgebildeten piezoelektrischen Kristall umfasst.

26. Kopf zur Verwendung in einer Substratvorbereitungsvorrichtung nach Anspruch 25, bei dem der Wandler an eine Hochfrequenzquelle angeschlossen ist und der in dem Wandler vorgesehene piezoelektrische Kristall in der Lage ist, Hochfrequenzsignale zu empfangen und akustische Energie zu erzeugen.

27. Kopf zur Verwendung in einer Substratvorbereitungsvorrichtung nach Anspruch 23, bei dem die akustische Energie mindestens entweder Ultraschallwellen oder Megaschallwellen umfasst.

## Revendications

1. Système de préparation de substrat (100) comprenant :
- une tête (106a, 106b) ayant une surface de tête configurée pour être à proximité d'une surface (108a, 108b) du substrat (108) lors du fonctionnement ;
- un premier conduit (302) conçu pour amener un premier liquide à la surface (108a, 108b) du substrat (108) à travers la tête (106a, 106b) ;
- un deuxième conduit (306) conçu pour amener un second liquide à la surface (108a, 108b) du substrat (108) à travers la tête (106a, 106b), le second liquide étant différent du premier liquide ; et
un troisième conduit (304) conçu pour évacuer chaque premier et second liquide de la surface (108a, 108b) du substrat (108), **caractérisé en ce que** le premier conduit (302), le second conduit (306) et le troisième conduit (304) sont configurés pour agir simultanément lors du fonctionnement.

2. Système de préparation de substrat selon la revendication 1, dans lequel le substrat (108) se déplace de telle sorte que la tête (106a, 106b) traverse la surface (108a, 108b) du substrat (108).

3. Système de préparation de substrat selon la revendication 1, dans lequel la tête (106a, 106b) se déplace pour traverser la surface (108a, 108b) du substrat (108).

4. Système de préparation de substrat selon la revendication 1, dans lequel la tête (106a, 106b) s'étend en taille jusqu'à un diamètre du substrat (108).

5. Système de préparation de substrat selon la revendication 1, dans lequel la tête (106a, 106b) a une longueur plus large qu'un diamètre du substrat (108).

6. Système de préparation de substrat selon la revendication 1, dans lequel une seconde tête est positionnée sur un côté opposé de la tête et conçue pour être à proximité d'une surface inférieure du substrat (108) lors du fonctionnement.

7. Système de préparation de substrat selon la revendication 1, dans lequel le premier liquide est de l'eau déminéralisée (DIW) et un liquide de nettoyage.

8. Système de préparation de substrat selon la revendication 1, dans lequel le second liquide est de la vapeur d'alcool isopropylique (IPA), de l'azote, des composés organiques, de l'hexanol, de l'éthylglycol, et des composés miscibles dans l'eau.

9. Procédé pour traiter un substrat, comprenant :
- l'application d'un premier liquide sur une surface (108a, 108b) d'un substrat (108) ;
- l'application d'un second liquide sur la surface (108a, 108b) du substrat (108), le second liquide étant appliqué à proximité immédiate de l'application du premier liquide ; et
- l'évacuation du premier liquide et du second liquide de la surface (108a, 108b) du substrat (108), l'évacuation étant réalisée juste lorsque le premier liquide et le deuxième liquide sont appliqués à la surface (108a, 108b) du substrat (108).
dans lequel l'application et l'évacuation forment un ménisque contrôlé (116).

10. Procédé pour traiter un substrat selon la revendication 9, dans lequel le premier liquide est de la DIW et un liquide de nettoyage.

11. Procédé pour traiter un substrat selon la revendication 9, dans lequel le premier liquide est de la vapeur d'alcool isopropylique (IPA), de l'azote, des composés organiques, de l'hexanol, de l'éthylglycol, et des composés miscibles dans l'eau.

12. Procédé pour traiter un substrat selon la revendication 9, dans lequel l'évacuation du premier liquide et du second liquide comprend l'application d'un vide à proximité immédiate de la surface (108a, 108b) du substrat (108).

13. Procédé pour traiter un substrat selon la revendication 12, dans lequel l'application du vide comprend l'ajustement d'une grandeur du vide pour former le ménisque stable.

14. Appareil de préparation de substrat (100) devant être utilisé dans des opérations de traitement de substrat, comprenant :
- une tête de proximité (106a, 106b) pouvant se déplacer vers une surface de substrat (108a, 108b), la tête de proximité (106a, 106b) comprenant :
- au moins une première entrée de source (302), la première entrée de source (302) étant conçue pour appliquer un premier liquide vers la surface du substrat (108a, 108b) lorsque la tête de proximité (106a, 106b) est dans une position qui est proche de la surface du substrat (108a, 108b) ;
- au moins une seconde entrée de source (306), la seconde entrée de source (306) étant conçue pour appliquer un second liquide vers la surface du substrat (108a, 108b) lorsque la tête de proximité (106a, 106b) est dans la position qui est proche de la surface du substrat (108a, 108b) ; et
- au moins une sortie de source (304), la sortie de source (304) étant conçue pour appliquer une pression de vide pour évacuer le premier liquide et le second liquide de la surface du substrat (108a, 108b)lorsque la tête de proximité (106a, 106b) est dans la position qui est proche de la surface du substrat (108a, 108b).

15. Appareil de préparation de substrat selon la revendication 14, dans lequel la première entrée (302) est configurée pour introduire une vapeur d'alcool isopropylique (IPA) vers le substrat.

16. Appareil de préparation de substrat selon la revendication 14, dans lequel la seconde entrée (306) est configurée pour introduire de l'eau déminéralisée (DIW) vers le substrat.

17. Appareil de préparation de substrat selon la revendication 14, dans lequel la tête de proximité (106a, 106b) est configurée pour produire un ménisque sur le substrat lorsque la tête de proximité (106a, 106b) est déplacée à proximité immédiate du substrat (108).

18. Appareil de préparation de substrat selon la revendication 14, comprenant en outre :
- un ensemble support de tête de proximité configuré pour déplacer la tête de proximité (106a, 106b) selon un mouvement linéaire le long d'un rayon du substrat.

19. Procédé de traitement d'un substrat selon la revendication 9, dans lequel la génération du ménisque liquide comprend :
- l'application d'un premier liquide sur une première région de la surface (108a, 108b) du substrat ;
- l'application d'un second liquide sur une seconde région de la surface (108a, 108b) du substrat, et
- l'évacuation du premier liquide et du second liquide de la surface (108a, 108b) du substrat, l'évacuation se produisant à partir d'une troisième région qui entoure sensiblement la première région ;
dans lequel la seconde région entoure sensiblement au moins une partie de la troisième région, et l'application et l'évacuation forme le ménisque liquide.

20. Procédé de traitement de substrat selon la revendication 19, dans lequel le premier liquide est un liquide de nettoyage.

21. Procédé de traitement de substrat selon la revendication 19, dans lequel le second liquide est de la vapeur d'alcool isopropylique (IPA), de l'azote, des composés organiques, de l'hexanol, de l'éthylglycol, et des composés miscibles dans l'eau.

22. Procédé de traitement de substrat selon la revendication 19, dans lequel l'évacuation du premier liquide et du second liquide comprend l'application d'un vide à proximité immédiate de la surface (108a, 108b) du substrat.

23. Tête (106a, 106b) utilisée dans un appareil de préparation de substrat (100), comprenant :
- au moins une première entrée de source (302) conçue pour amener un premier liquide à la surface (108a, 108b) du substrat (108) à travers la tête (106a, 106b) ;
- au moins une seconde entrée de source (306) conçue pour amener un second liquide à la surface (108a, 108b) du substrat (108) à travers la tête (106a, 106b), le second liquide étant différent du premier liquide ; et
- au moins une sortie de source (304) conçue pour évacuer chacun du premier et du second liquide de la surface (108a, 108b) du substrat (108), au moins une partie d'au moins une sortie de source étant placée entre au moins la première entrée de source (302) et au moins la seconde entrée de source (306), et au moins la première entrée de source (302), au moins la seconde entrée de source (306) et au moins la sortie de source (304) étant configurée pour agir simultanément lors du fonctionnement ; et
- un transducteur (406) étant capable d'appliquer l'énergie acoustique au premier liquide ;
dans lequel au moins la seconde entrée de source (306) entoure au moins un bord arrière d'au moins une sortie de source (304).

24. Tête utilisée dans un appareil de préparation de substrat selon la revendication 23, dans lequel le premier liquide est un produit chimique de nettoyage.

25. Tête utilisée dans un appareil de préparation de substrat selon la revendication 23, dans lequel le transducteur (406) comprend un corps et un cristal piézoélectrique défini dans le corps.

26. Tête utilisée dans un appareil de préparation de substrat selon la revendication 25, dans lequel le transducteur est fixé à une alimentation RF et le cristal piézoélectrique à l'intérieur du transducteur est capable de recevoir la RF et de générer de l'énergie acoustique.

27. Tête utilisée dans un appareil de préparation de substrat selon la revendication 23, dans lequel l'énergie acoustique comprend au moins des ondes ultrasoniques et des ondes mégasoniques.
